(19) Europäisches Patentamt
European Patent Office
Office européen des brevets

(11) **EP 4 779 641 A1**

(12) **EUROPEAN PATENT APPLICATION**

(43) Date of publication:
**22.07.2026 Bulletin 2026/30**

(21) Application number: **25191191.3**

(22) Date of filing: **23.07.2025**

(51) International Patent Classification (IPC):
**G11C 16/34** (2006.01)   **G11C 29/52** (2006.01)
**G11C 16/26** (2006.01)   G11C 16/04 (2006.01)

(52) Cooperative Patent Classification (CPC):
**G11C 16/3418; G11C 16/26; G11C 29/52;**
G11C 16/0483

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **15.01.2025 JP 2025005553**

(71) Applicant: **Kioxia Corporation**
**Tokyo 108-0023 (JP)**

(72) Inventors:
• **KAMIJO, Yuki**
**Minato-ku, Tokyo, 108-0023 (JP)**
• **TAKIZAWA, Kazutaka**
**Minato-ku, Tokyo, 108-0023 (JP)**
• **AMAKI, Takehiko**
**Minato-ku, Tokyo, 108-0023 (JP)**
• **IGAHARA, Shunichi**
**Minato-ku, Tokyo, 108-0023 (JP)**

(74) Representative: **Hoffmann Eitle**
**Patent- und Rechtsanwälte PartmbB**
**Arabellastraße 30**
**81925 München (DE)**

(54) **MEMORY SYSTEM, MEMORY DEVICE AND METHOD**

(57) According to one embodiment, a memory system includes: a memory device that includes a plurality of memory cells; and a memory controller configured to cause the memory device to execute a read operation a plurality of times using read levels respectively. Any two adjacent read levels of the read levels have the same interval. A plurality of first bit counts are calculated using ON-cells in each read operations using each read level. A second bit count and a third bit count are calculated using the first bit counts, the second bit count and the third bit count being respectively corresponding to a fourth voltage range and a fifth voltage range that have voltage ranges different from each other.

FIG. 15

Processed by Luminess, 75001 PARIS (FR)

**Description**

CROSS-REFERENCE TO RELATED APPLICATIONS

This application is based upon and claims the benefit of priority from Japanese Patent Application No. 2025-005553, filed January 15, 2025, the entire contents of which are incorporated herein by reference.

FIELD

Embodiments described herein relate generally to a memory system.

BACKGROUND

A memory system including a memory device capable of storing data in a nonvolatile manner and a controller that controls the memory device is known.

BRIEF DESCRIPTION OF DRAWINGS

FIG. 1 is a block diagram illustrating an example of a configuration of a memory system according to a first embodiment.
FIG. 2 is a block diagram illustrating an example of a configuration of a memory controller included in the memory system according to the first embodiment.
FIG. 3 is a block diagram illustrating an example of a configuration of a memory device included in the memory system according to the first embodiment.
FIG. 4 is a diagram illustrating an example of a circuit configuration of a memory cell array included in the memory system according to the first embodiment.
FIG. 5 is a diagram illustrating an example of a circuit configuration of a row decoder module included in the memory system according to the first embodiment.
FIG. 6 is a diagram illustrating an example of a circuit configuration of a data register and a sense amplifier module included in the memory system according to the first embodiment.
FIG. 7 is a diagram illustrating an example of threshold voltage distribution of memory cell transistors and data assignment in the memory system according to the first embodiment.
FIG. 8 is a diagram for explaining shift reading executed in the memory system according to the first embodiment.
FIG. 9 is a schematic diagram for explaining an optimum read level calculated in the memory system according to the first embodiment.
FIG. 10 is a schematic diagram illustrating an example of two adjacent states symmetrically distributed in the threshold voltage distribution of the memory system according to the first embodiment.
FIG. 11 is a schematic diagram illustrating an example of two adjacent states asymmetrically distributed in the threshold voltage distribution of the memory system according to the first embodiment.
FIG. 12 is a schematic diagram illustrating an example of distribution of varied threshold voltages of the memory cell transistors according to the first embodiment.
FIG. 13 is a flowchart illustrating an example of an outline of a Vth tracking operation executed in the memory system according to the first embodiment.
FIG. 14 is a flowchart for explaining an example of a part of the Vth tracking operation executed in the memory system according to the first embodiment.
FIG. 15 is a flowchart for explaining an example of another part of the Vth tracking operation executed in the memory system according to the first embodiment.
FIG. 16 is a diagram illustrating an example of a step count table used in the memory system according to the first embodiment.
FIG. 17 is a diagram for explaining an example of steps set in the memory system according to the first embodiment.
FIG. 18 is a diagram for explaining a relationship between a step set in the memory system according to the first embodiment and a voltage range including a valley position.
FIG. 19 is a diagram for explaining a relationship between a step set in the memory system according to the first embodiment and a voltage range including a valley position.
FIG. 20 is a diagram for explaining a relationship between a step set in the memory system according to the first embodiment and a voltage range including a valley position.

FIG. 21 is a diagram for explaining calculation of a difference bit count in each step set in the memory system according to the first embodiment.

FIG. 22 is a diagram for explaining a voltage set for calculating an optimum read level in the memory system according to the first embodiment.

FIG. 23 is a diagram for explaining an optimum read level obtained by internal division in the memory system according to the first embodiment.

FIG. 24 is a diagram for explaining an example of an adjustment parameter used in the memory system according to the first embodiment.

FIG. 25 is a diagram illustrating an example of an adjustment parameter table used in the memory system according to the first embodiment.

FIG. 26 is a diagram for explaining an example of a deviation between an actual optimum read level and a voltage obtained by internal division in the memory system according to the first embodiment.

FIG. 27 is a diagram for explaining another example of the deviation between the actual optimum read level and the voltage obtained by the internal division in the memory system according to the first embodiment.

FIG. 28 is a diagram illustrating an example of a correction coefficient table used in the memory system according to the first embodiment.

FIG. 29 is a diagram for explaining an example of a correction coefficient used in the memory system according to the first embodiment.

FIG. 30 is a diagram for explaining an optimum read level calculated in consideration of a deviation in the memory system according to the first embodiment.

FIG. 31 is a diagram for explaining an optimum read level calculated in consideration of a deviation in the memory system according to the first embodiment.

FIG. 32 is a schematic diagram for explaining an example of calculation of an optimum read level in the Vth tracking operation executed in the memory system according to the first embodiment.

FIG. 33 is a diagram for explaining an example of reducing a deviation between a calculated optimum read level and an actual optimum read level in the memory system according to the first embodiment.

FIG. 34 is a diagram for explaining another example of reducing the deviation between the calculated optimum read level and the actual optimum read level in the memory system according to the first embodiment.

FIG. 35 is a schematic diagram for explaining another example of the calculation of the optimum read level in the Vth tracking operation executed in the memory system according to the first embodiment.

FIG. 36 is a diagram for explaining an example of reducing a deviation between a calculated optimum read level and an actual optimum read level in the memory system according to the first embodiment.

FIG. 37 is a diagram for explaining another example of reducing the deviation between the calculated optimum read level and the actual optimum read level in the memory system according to the first embodiment.

FIG. 38 is a block diagram illustrating an example of a hardware configuration of a memory controller included in a memory system according to a first further embodiment of the first embodiment.

FIG. 39 is a flowchart for explaining an example of a part of the Vth tracking operation executed in the memory system according to the first further embodiment of the first embodiment.

FIG. 40 is a block diagram illustrating an example of a hardware configuration of a memory controller included in a memory system according to a second further embodiment of the first embodiment.

FIG. 41 is a flowchart for explaining an example of a part of the Vth tracking operation executed in the memory system according to the second further embodiment of the first embodiment.

FIG. 42 is a flowchart for explaining an example of a Vth tracking operation executed in a memory system according to a second embodiment.

FIG. 43 is a flowchart for explaining an example of a part of the Vth tracking operation executed in the memory system according to the second embodiment.

FIG. 44 is a schematic diagram for explaining an example of a slope ratio calculated in the memory system according to the second embodiment.

FIG. 45 is a flowchart for explaining an example of another part of the Vth tracking operation executed in the memory system according to the second embodiment.

FIG. 46 is a diagram illustrating an example of a step count table used in the memory system according to the second embodiment.

## DETAILED DESCRIPTION

In general, according to one embodiment, a memory system includes: a memory device that includes a plurality of memory cells each, of the plurality of memory cells being configured to store, in a nonvolatile manner, at least data of a first value and data of a second value according to a threshold voltage, the first value corresponding to the threshold voltage included in a first voltage range, the second value corresponding to the threshold voltage included in a second voltage range different from the first voltage range, the plurality of memory cells including at least a plurality of first memory cells and a plurality of second memory cells; and a memory controller configured to the write data of the first value to each of the plurality of first memory cells, write the data of the second value to each of the plurality of second memory cells, and cause, in a tracking operation, the memory device to execute a read operation a plurality of times on the plurality of memory cells using a plurality of read levels respectively, any two adjacent read levels of the plurality of read levels having the same interval, the plurality of read levels being within a third voltage range that includes at least a part of the first voltage range and at least a part of the second voltage range. In the tracking operation, the number of ON-cells, which is the number of memory cells that turn on among the plurality of memory cells, is acquired in each read operation using each read level, a plurality of first bit counts are calculated, each of the plurality of first bit counts being a difference in the numbers of ON-cells in each of two read operations using the two adjacent read levels, and a second bit count and a third bit count are calculated using the plurality of first bit counts, the second bit count corresponding to a fourth voltage range included in the third voltage range, the second bit count being a difference in the numbers of ON-cells in two read operations respectively using a read level equivalent to a lower limit voltage of the fourth voltage range and a read level equivalent to an upper limit voltage of the fourth voltage range, among the plurality of read levels, the third bit count corresponding to a fifth voltage range included in the third voltage range, the fifth voltage range having a voltage range different from the fourth voltage range, the third bit count being a difference in the numbers of ON-cells in two read operations respectively using a read level equivalent to a lower limit voltage of the fifth voltage range and a read level equivalent to an upper limit voltage of the fifth voltage range, among the plurality of read levels.

Hereinafter, each embodiment will be described with reference to the drawings. Each embodiment exemplifies an apparatus and a method for embodying the technical idea of the invention. The drawings are schematic or conceptual. The illustration of the configuration is omitted as appropriate. Components having substantially the same functions and configurations are denoted by the same reference numerals. Numbers and the like added to the reference numerals are referred to by the same reference numerals and are used to distinguish among similar elements.

1 First Embodiment

1.1 Configuration

1.1.1 Memory System

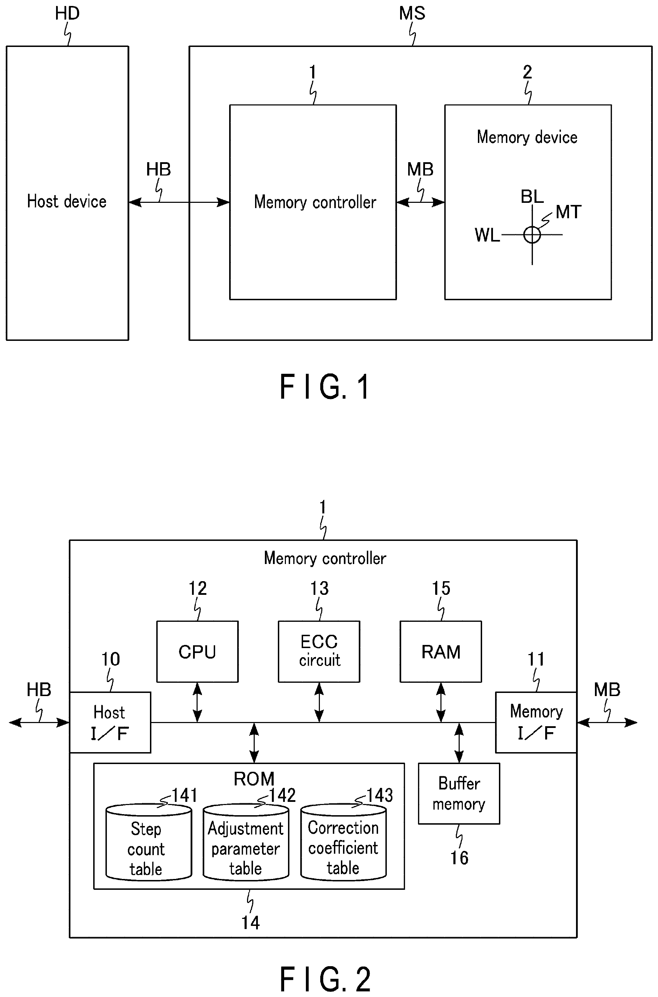

A configuration example of a memory system will be described with reference to FIG. 1. FIG. 1 is a block diagram illustrating an example of a configuration of a memory system according to a first embodiment.

A memory system MS can be connected to an external host device HD. The memory system MS is a memory card or a storage device such as a solid state drive (SSD). The memory system MS includes, for example, a memory controller 1 and at least one memory device 2. In the memory system MS, the memory controller 1 and the at least one memory device 2 may be configured as one semiconductor device. The host device HD is an electronic device such as a personal computer, a mobile information terminal, or a server.

The memory controller 1 is, for example, a semiconductor integrated circuit configured as a system-on-a-chip (SoC), an application specific integrated circuit (ASIC), or a field-programmable gate array (FPGA). The memory controller 1 has a function of managing and controlling the memory device 2. The memory controller 1 may be referred to as an external device that manages and controls the memory device 2 from the outside of the memory device 2. The memory controller 1 is connected to the host device HD via a host bus HB. The memory controller 1 is connected to the memory device 2 via a memory bus MB. The memory controller 1 can control the memory device 2 based on a request received from the host device HD. For example, the memory controller 1 can control the memory device 2 to execute a read operation, a write operation, an erase operation, and the like.

The memory device 2 is a semiconductor memory device configured to store data in a nonvolatile manner. The memory device 2 is, for example, a NAND flash memory. In the NAND flash memory, a unit of a data read operation and a data write operation is referred to as a page. The memory device 2 includes a plurality of memory cell transistors MT, a plurality of bit lines BL, and a plurality of word lines WL. For example, each memory cell transistor MT is associated with one bit line BL and one word line WL. A column address is assigned to each bit line BL. A page address is assigned to each word line WL. 1.1.2 Memory Controller

A configuration example of the memory controller 1 will be described with reference to FIG. 2. FIG. 2 is a block diagram illustrating an example of a configuration of the memory controller included in the memory system according to the first embodiment.

The memory controller 1 includes, for example, a host interface circuit (host I/F) 10, a memory interface circuit (memory I/F) 11, a central processing unit (CPU) 12, an error checking and correcting (ECC) circuit 13, a read only memory (ROM) 14, a random access memory (RAM) 15, and a buffer memory 16. The host I/F 10, the memory I/F 11, the CPU 12, the ECC circuit 13, the ROM 14, the RAM 15, and the buffer memory 16 may be connected to an internal bus.

The host I/F 10 controls communication between the host device HD and the memory controller 1 according to an interface standard. The host I/F 10 is connected to the host device HD via the host bus HB. The host I/F 10 supports interface standards such as Serial Advanced Technology Attachment (SATA), Serial Attached SCSI (SAS), PCI Express (PCIe™), and Non-Volatile Memory Express™ (NVMe™).

The memory I/F 11 controls communication between the memory controller 1 and the memory device 2 according to an interface standard. The memory I/F 11 is connected to the memory device 2 via the memory bus MB. The memory I/F 11 supports interface standards such as Toggle DDR and Open NAND Flash Interface (ONFI).

The CPU 12 is a processor that controls the entire operation of the memory controller 1. The CPU 12 instructs the memory device 2 to perform a data write operation via the memory I/F 11 according to a write request received via the host I/F 10. The CPU 12 instructs the memory device 2 to perform a data read operation via the memory I/F 11 according to a read request received via the host I/F 10.

The ECC circuit 13 is a circuit that executes an ECC process. The ECC process includes the encoding and decoding of data. The ECC circuit 13 encodes data to be written to the memory device 2 and decodes data read from the memory device 2.

The ROM 14 is a nonvolatile memory. The ROM 14 is, for example, an electrically erasable programmable read-only memory (EEPROM™). The ROM 14 stores, for example, a program such as firmware and management data. The CPU 12 executes various processes by executing the firmware stored in the ROM 14 or the like. The management data is, for example, various tables including a step count table 141, an adjustment parameter table 142, and a correction coefficient table 143. These tables are tables used to determine a read voltage at which the number of fail bits is minimized. Details of these tables will be described later.

The RAM 15 is a volatile memory. The RAM 15 is, for example, a static random access memory (SRAM) or a dynamic random access memory (DRAM). The RAM 15 is used as a work area of the CPU 12.

The buffer memory 16 is, for example, a volatile memory. The buffer memory 16 is, for example, a DRAM or an SRAM. The buffer memory 16 may be implemented outside the memory controller 1. The buffer memory 16 temporarily stores data received via the host I/F 10, data received via the memory I/F 11, and the like.

1.1.3 Memory Device

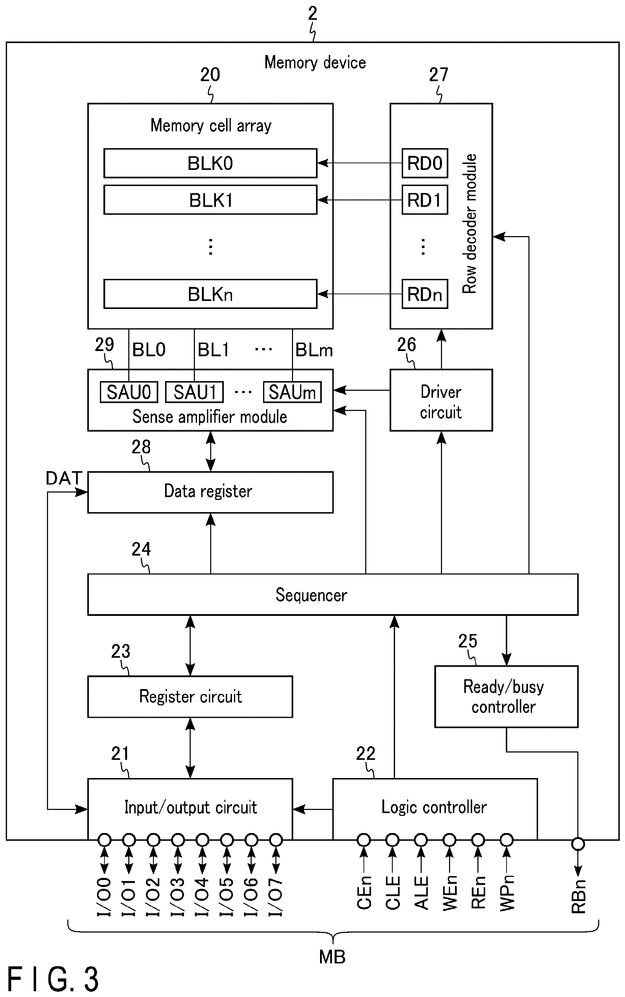

A configuration example of the memory device 2 will be described with reference to FIG. 3. FIG. 3 is a block diagram illustrating an example of a configuration of the memory device included in the memory system according to the first embodiment.

The memory device 2 includes, for example, a memory cell array 20 and a peripheral circuit that manages and controls the memory cell array 20. The peripheral circuit includes, for example, an input/output circuit 21, a logic controller 22, a register circuit 23, a sequencer 24, a ready/busy controller 25, a driver circuit 26, a row decoder module 27, a data register 28, and a sense amplifier module 29. The signals transmitted and received via the memory bus MB include, for example, input/output signals I/O0 to I/O7, control signals CEn, CLE, ALE, WEn, REn, and WPn, and a ready/busy signal RBn.

The memory cell array 20 is a set of the memory cell transistors MT. The memory cell array 20 includes (n+1) blocks BLKO to BLKn. The value n is an integer of one or larger. The block BLK is, for example, a unit of a data erase operation. A block address is assigned to each block BLK. In the memory cell array 20, (m+1) bit lines BLO to BLm and a plurality of word lines WL (not illustrated in FIG. 3) are provided. The value m is an integer of one or larger.

The input/output circuit 21 controls transmission and reception (input and output) of the input/output signals I/O0 to I/O7. The input/output signal I/O can include, for example, data DAT, status information, an address, and a command. The input/output circuit 21 can input and output the data DAT between the data register 28 and the memory controller 1. The input/output circuit 21 can output, to the memory controller 1, the status information transferred from the register circuit 23. The input/output circuit 21 can output, to the register circuit 23, each of the address and the command transferred from the memory controller 1.

The logic controller 22 controls each of the input/output circuit 21 and the sequencer 24 based on each control signal input from the memory controller 1. The logic controller 22 enables the memory device 2 based on the control signal CEn. The logic controller 22 notifies the input/output circuit 21 that the input/output signals I/O received by the memory device 2 are a command and an address respectively, based on the control signals CLE and ALE. The logic controller 22 instructs the input/output circuit 21 to receive the input/output signal I/O based on the control signal WEn, and instructs the input/output circuit 21 to transmit the input/output signal I/O based on the control signal REn. The logic controller 22 sets the memory device 2 to a protection state based on the control signal WPn.

The register circuit 23 temporarily stores status information, an address, a command, and the like. The status information is information indicating an operation state of the memory device 2. The status information is updated based on the control by the sequencer 24 and transferred to the memory controller 1 via the input/output circuit 21. The address may include a block address, a page address, a column address, and the like. The command includes instructions for various operations of the memory device 2.

The sequencer 24 is a controller that controls the entire operation of the memory device 2. The sequencer 24 executes a read operation, a write operation, an erase operation, and the like based on the command and the address stored in the register circuit 23.

The ready/busy controller 25 generates a ready/busy signal RBn based on the control by the sequencer 24. The ready/busy signal RBn is a signal for notifying the memory controller 1 whether the memory device 2 is in a ready state or a busy state. The ready state is a state in which the memory device 2 can receive a command from the memory controller 1, and is notified by a high-level ready/busy signal RBn. The busy state is a state in which the memory device 2 cannot receive a command from the memory controller 1, and is notified by a low-level ready/busy signal RBn.

The driver circuit 26 generates a voltage used in the read operation, write operation, erase operation, and the like. The driver circuit 26 supplies the generated voltage to the row decoder module 27 and the sense amplifier module 29.

The row decoder module 27 is a circuit used for selecting a block BLK and supplying a voltage to a wiring such as a word line WL. The row decoder module 27 includes a plurality of row decoders RDO to RDn. The row decoders RDO to RDn are associated with the blocks BLKO to BLKn, respectively. Each row decoder RD can set the associated block BLK to be selected or non-selected based on the block address.

The data register 28 is a circuit that temporarily stores the data DAT. The data register 28 may be used to input and output the data DAT between the input/output circuit 21 and the sense amplifier module 29. The data register 28 is also referred to as a data latch, a page register, or a cache memory.

The sense amplifier module 29 is a circuit used for supplying a voltage to each bit line BL and reading data. The sense amplifier module 29 includes a plurality of sense amplifier units SAUO to SAUm. The sense amplifier units SAU0 to SAUm are associated with the bit lines BL0 to BLm, respectively. Each sense amplifier unit SAU may determine data read from the selected memory cell transistor MT based on a voltage of the associated bit line BL.

1.1.3.1 Memory Cell Array

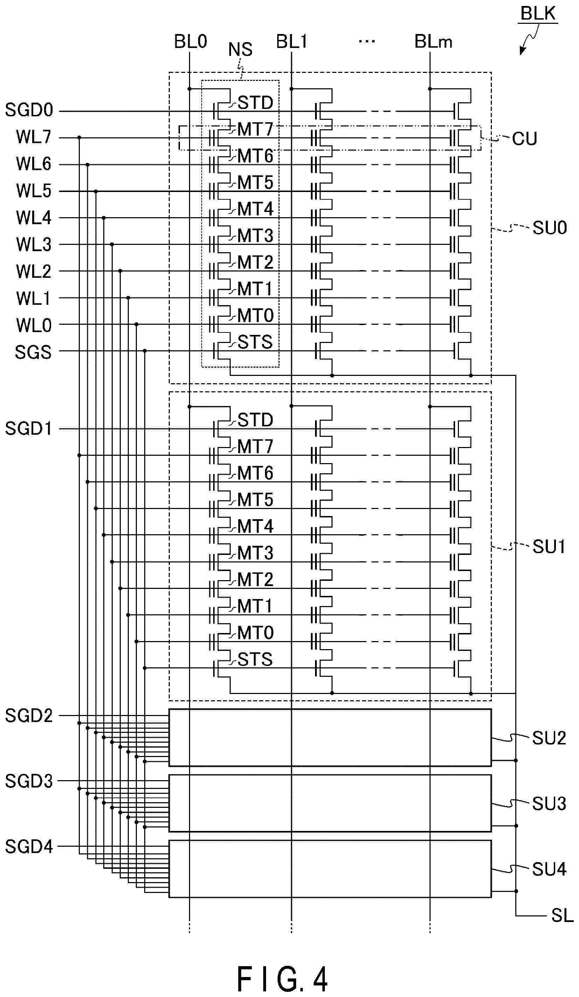

A configuration example of the memory cell array 20 included in the memory device 2 will be described with reference to FIG. 4. FIG. 4 is a diagram illustrating an example of a circuit configuration of the memory cell array included in the memory system according to the first embodiment. FIG. 4 illustrates a configuration of one of the blocks BLK included in the memory cell array 20.

In a block BLK, the bit lines BLO to BLm, a plurality of word lines WLO to WL7, select gate lines SGDO to SGD4, a select gate line SGS, and a source line SL are provided. The select gate lines SGDO to SGD4 and SGS and the word lines WLO to WL7 are provided for each block BLK. The bit lines BLO to BLm are shared by the blocks BLK. The source line SL may be shared by the blocks BLK, or may be provided for each block BLK.

The block BLK includes, for example, five string units SUO to SU4. Each string unit SU includes a plurality of NAND strings NS. The NAND strings NS are associated with the bit lines BL0 to BLm, respectively. In other words, each bit line BL is shared by the NAND strings NS to which the same column address is assigned among the blocks BLK. Each NAND string NS is connected between the associated bit line BL and source line SL.

Each NAND string NS includes, for example, memory cell transistors MTO to MT7 and select transistors STD and STS. Each memory cell transistor MT is a memory cell including a control gate and a charge storage layer, and holds (stores) data in a nonvolatile manner. The threshold voltage of the memory cell transistor MT can be changed based on the amount of charge injected into the charge storage layer or the like. The memory cell transistor MT stores data corresponding to the threshold voltage. Each of the select transistors STD and STS is used to select the string unit SU.

In each NAND string NS, the select transistor STD, the memory cell transistors MT7 to MTO, and the select transistor STS are connected in series in this order. Specifically, the drain of the select transistor STD is connected to the associated bit line BL. The source of the select transistor STD is connected to the drain of the memory cell transistor MT7. The drain of the select transistor STS is connected to the source of the memory cell transistor MTO. The source of the select transistor STS is connected to the source line SL. The memory cell transistors MTO to MT7 are connected in series between the select transistors STD and STS.

The select gate lines SGDO to SGD4 are associated with the string units SU0 to SU4, respectively. Each select gate line SGD is connected to the gate of each of the select transistors STD included in the associated string unit SU. The select gate line SGS is connected to the gate of each of the select transistors STS included in the associated block BLK. The word lines WL0 to WL7 are respectively connected to the control gates of the memory cell transistors MT0 to MT7 included in the associated block BLK.

A set of the memory cell transistors MT commonly connected to the word line WL in a string unit SU is referred to as a cell unit CU. A set of one-bit data stored in each of the memory cell transistors MT included in the cell unit CU is referred to as page data. The cell unit CU can store two or more pages of data according to the number of bits of data stored in each memory cell transistor MT.

Note that the circuit configuration of the memory cell array 20 is not limited to the above. For example, the number of the string units SU included in each block BLK and the number of the memory cell transistors MT and the select transistors STD and STS included in each NAND string NS can be designed to any numbers.

1.1.3.2 Row Decoder Module

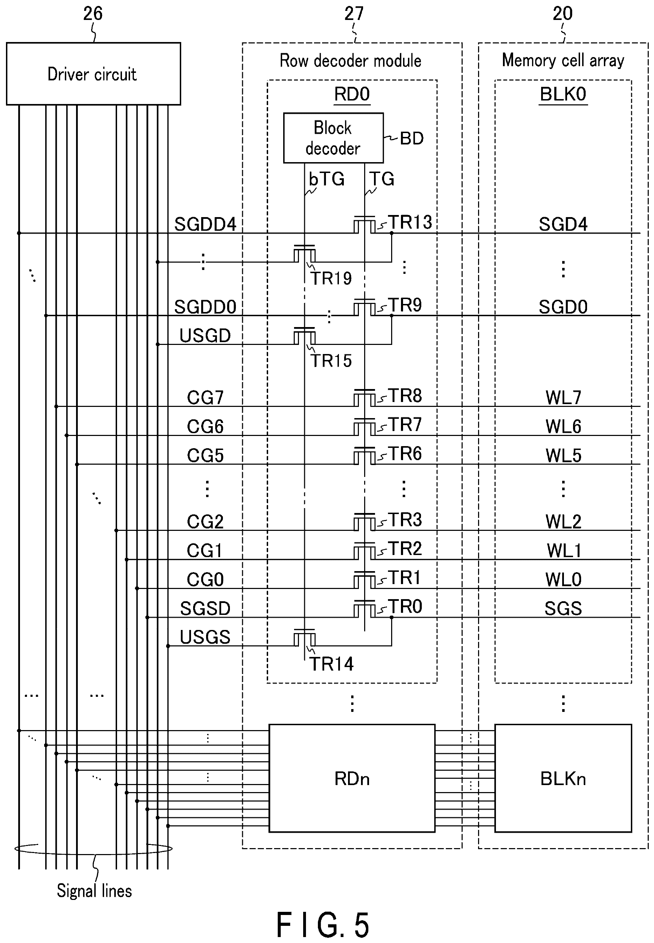

A configuration example of the row decoder module 27 included in the memory device 2 will be described with reference to FIG. 5. FIG. 5 is a diagram illustrating an example of a circuit configuration of the row decoder module included in the memory system according to the first embodiment. The configurations of the row decoders RD are substantially equivalent to each other. Therefore, in FIG. 5 and the following description, the configuration of a row decoder RDO will be mainly described, and the detailed configurations of row decoders RD1 to RDn will not be illustrated and described.

Each row decoder RD is connected to signal lines CG0 to CG7, SGDDO to SGDD4, SGSD, USGD, and USGS which are connected to the driver circuit 26. Further, each row decoder RD is connected to the word lines WLO to WL7 of the associated block BLK and the select gate lines SGDO to SGD4 and SGS.

The row decoder RD0 includes, for example, transistors TRO to TR19, transfer gate lines TG and bTG, and a block decoder BD. Each of the transistors TRO to TR19 is an N-type high-voltage transistor. The transfer gate line TG is connected to the gates of the transistors TRO to TR13. The transfer gate line bTG is connected to the gates of the transistors TR14 to TR19. The drains of the transistors TR0 to TR13 are connected to the signal lines SGSD, CG0 to CG7, and SGDDO to SGDD4, respectively. The sources of the transistors TRO to TR13 are connected to the select gate line SGS, the word lines WLO to WL7, and the select gate lines SGDO to SGD4 of the block BLKO, respectively. The drain and the source of the transistor TR14 are connected to the signal line USGS and the select gate line SGS of the block BLKO, respectively. The drains of the transistors TR15 to TR19 are connected to the signal line USGD. The sources of the transistors TR15 to TR19 are connected to the select gate lines SGDO to SGD4 of the block BLKO, respectively.

The block decoder BD is a circuit that decodes a block address. The block decoder BD applies one of a high-level voltage and a low-level voltage to the transfer gate line TG and applies the other of the high-level voltage and the low-level voltage to the transfer gate line bTG based on the decoding result of the block address. Specifically, the block decoder BD of the selected block BLK applies a high-level voltage to the transfer gate line TG and applies a low-level voltage to the transfer gate line bTG. The block decoder BD of the non-selected block BLK applies a low-level voltage to the transfer gate line TG and applies a high-level voltage to the transfer gate line bTG. As a result, the voltages of the signal lines CGO to CG7 are respectively applied to the word lines WLO to WL7 of the selected block BLK, the voltages of the signal lines SGDDO to SGDD4 and SGSD are respectively applied to the select gate lines SGDO to SGD4 and SGS of the selected block BLK, and the voltages of the signal lines USGD and USGS are respectively applied to the select gate lines SGD and SGS of the non-selected block BLK.

Note that the circuit configuration of the row decoder module 27 is not limited to the above. For example, the number of transistors TR included in the row decoder module 27 can be appropriately changed according to the number of wirings of each block BLK. Since the signal line CG is shared by the blocks BLK, the signal line CG is also referred to as a global word line. Since the word line WL is provided for each block, the word line WL is also referred to as a local word line. Since each of the signal lines SGDD and SGSD is shared by the blocks BLK, the signal lines SGDD and SGSD are also referred to as global select gate lines. Each of the select gate lines SGD and SGS is provided for each block, and thus is also referred to as a local select gate line. 1.1.3.3 Data Register and Sense Amplifier Module

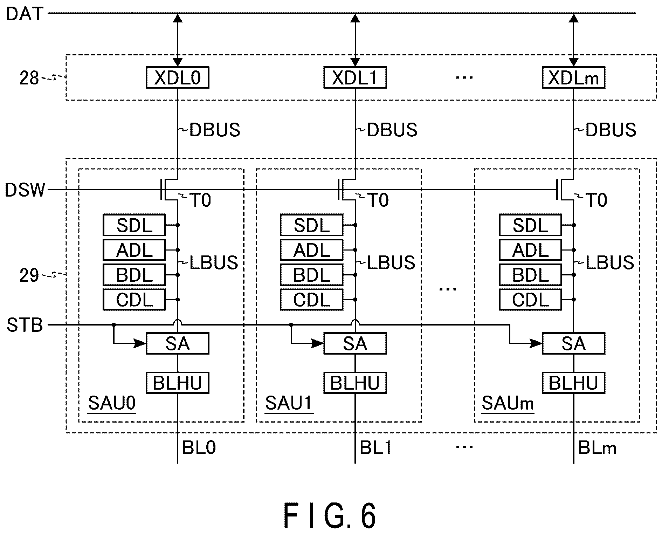

A configuration example of the data register 28 and the sense amplifier module 29 included in the memory device 2 will be described with reference to FIG. 6. FIG. 6 is a diagram illustrating an example of a circuit configuration of a data register and a sense amplifier module included in the memory system according to the first embodiment.

Each sense amplifier unit SAU includes, for example, a bit line hook up BLHU, a sense amplifier SA, buses DBUS and LBUS, latch circuits SDL, ADL, BDL and CDL, and a transistor T0. The data register 28 includes a plurality of latch circuits XDLO to XDLm. The latch circuits XDLO to XDLm are associated with the sense amplifier units SAU0 to SAUm, respectively. Each of the latch circuits XDL0 to XDLm is connected to the associated sense amplifier unit SAU via the bus DBUS.

The bit line hook up BLHU is, for example, a protective circuit that prevents a high voltage applied to the channel of the NAND string NS in the erase operation from being applied to the sense amplifier SA. The bit line hook up BLHU may be configured to be able to apply a predetermined voltage to the non-selected bit lines BL.

The sense amplifier SA is a circuit used for determining data based on the voltage of the bit line BL and applying a voltage to the bit line BL. Each sense amplifier SA is connected to the associated bit line BL via the bit line hook up BLHU. In a case where the control signal STB is asserted during a read operation, the sense amplifier SA determines whether the data read from the selected memory cell transistor MT is data "0" or data "1" based on the voltage of the associated bit line BL. The control signal STB is generated by, for example, the sequencer 24.

Each of the latch circuits SDL, ADL, BDL, and CDL can temporarily store data. The latch circuits SDL, ADL, BDL, and CDL, and the sense amplifier SA are configured to be able to transmit and receive data via the bus LBUS.

The transistor TO of each sense amplifier unit SAU controls signal transferring between the associated buses DBUS and LBUS. One end of the transistor TO of each sense amplifier unit SAU is connected to the associated bus DBUS. The other end of the transistor TO of each sense amplifier unit SAU is connected to the associated bus LBUS. The control signal DSW is input to the gate of the transistor TO of each sense amplifier unit. The control signal DSW is generated by, for example, the sequencer 24.

Each latch circuit XDL can temporarily store data. Each of the latch circuits XDL is configured to be able to transmit and receive data to and from the associated sense amplifier unit SAU via the bus DBUS. Each latch circuit XDL is used to input and output data DAT between the sense amplifier module 29 and the input/output circuit 21. Each latch circuit XDL may be shared by the sense amplifier units SAU.

Note that the circuit configuration of the sense amplifier module 29 is not limited to the above. For example, the number of latch circuits included in each sense amplifier unit SAU can be appropriately changed. The sense amplifier unit SAU may include an arithmetic circuit capable of executing a logical operation.

1.1.4 Threshold Voltage Distribution of Memory Cell Transistors

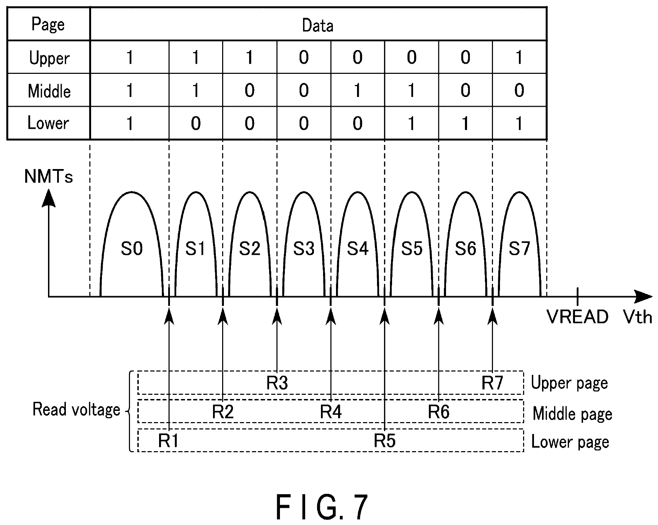

The threshold voltage distribution of the memory cell transistors MT included in the memory device 2 will be described with reference to FIG. 7. FIG. 7 is a diagram illustrating an example of threshold voltage distribution of the memory cell transistors and data assignment in the memory system according to the first embodiment. In the following drawings, the number of memory cell transistors MT is indicated as "NMTs". Also, in the following drawings, the threshold voltage of a memory cell transistor MT is indicated as "Vth".

In a case where a voltage is applied to the control gate, a memory cell transistor MT is turned on if the memory cell transistor MT has a threshold voltage lower than the applied voltage. In a case where a voltage is applied to the control gate, a memory cell transistor MT is turned off if the memory cell transistor MT has a threshold voltage equal to or higher than the applied voltage.

In the memory device 2, for example, eight states are formed by the threshold voltages of the memory cell transistors MT. Hereinafter, the eight states are referred to as a state S0, a state S1, a state S2, a state S3, a state S4, a state S5, a state S6, and a state S7 in order from a lower threshold voltage. Different pieces of three-bit data are respectively assigned to the memory cell transistors MT belonging to each of the states S0 to S7. Note that data of one bit, two bits, or four bits or more bits may be stored in each memory cell transistor MT, or data different from that described below may be assigned to each memory cell transistor MT.

The state S0 corresponds to, for example, the threshold voltage of a memory cell transistor MT on which the data erase operation is executed. The threshold voltage of the memory cell transistor MT included in the state S0 is lower than the voltage R1.

The states S1 to S7 correspond to a state in which charge is injected to the charge storage layer of a memory cell transistor MT. The threshold voltages of the memory cell transistors MT included in the states S1 to S6 are equal to or higher than the voltages R1 to R6 and lower than the voltages R2 to R7, respectively. The threshold voltage of a memory cell transistor MT included in state S7 is equal to or higher than the voltage R7 and lower than the voltage VREAD. The relationship of the voltages is R1 < R2 < R3 < R4 < R5 < R6 < R7 < VREAD. The voltage VREAD is a voltage that turns on a memory cell transistor MT when applied to the control gate thereof even if the threshold voltage of the memory cell transistor MT is any of states S0 to S7.

Hereinafter, an example of data assignment to memory cell transistors MT belonging to the respective eight states S0 to S7 will be described. The three-bit data stored in each memory cell transistor MT is also referred to as upper bit data, middle bit data, and lower bit data. Further, one-page data configured by upper bit data, middle bit data, and lower bit data stored in each of the memory cell transistors MT included in each cell unit CU is also referred to as upper page data, middle page data, and lower page data, respectively.

    State S0: data "1, 1, 1"
    State S1: data "1, 1, 0"
    State S2: data "1, 0, 0"
    State S3: data "0, 0, 0"
    State S4: data "0, 1, 0"
    State S5: data "0, 1, 1"
    State S6: data "0, 0, 1"
    State S7: data "1, 0, 1"

In a case where such data assignment is applied, the one-page data including the lower bits (lower page data) is determined by the read operation using each of the voltages R1 and R5. The one-page data including the middle bits (middle page data) is determined by the read operation using each of the voltages R2, R4, and R6. The one-page data including the upper bits (upper page data) is determined by the read operation using each of the voltages R3 and R7. Hereinafter, each of the voltages R1 to R7 is referred to as a read voltage or a read level.

1.2 Operation

An operation of the memory system MS will be described.

1.2.1 Shift Reading

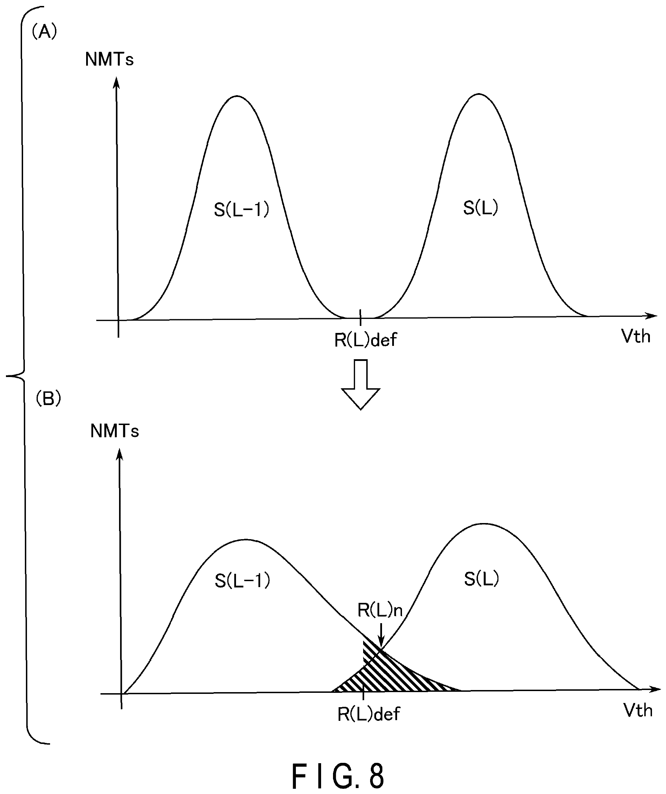

First, shift reading executed in the memory system MS according to the embodiment will be described with reference to FIG. 8. FIG. 8 is a diagram for explaining shift reading executed in the memory system according to the first embodiment. In FIG. 8, part (A) illustrates an example of two adjacent states S(L-1) and S(L) in the threshold voltage distribution immediately after writing. The value L is an integer that is one or larger and seven or smaller. In FIG. 8, part (B) illustrates an example of the two adjacent states S(L-1) and S(L) in the threshold voltage distribution in which the threshold voltage of the memory cell transistor MT varies. Note that, hereinafter, two states adjacent to each other are also simply referred to as two adjacent states.
The shift reading is performed, for example, in a case where data cannot be correctly read at a default read voltage.
As illustrated in part (A) of FIG. 8, in the threshold voltage distribution immediately after writing, for example, states S(L-1) and S(L) are separated from each other. Therefore, the memory controller 1 can read correct data by setting the read level R(L) to a default read level R(L)def between the states S(L-1) and S(L).
However, the threshold voltage of the memory cell transistor MT may vary due to a factor such as disturbance. With this configuration, in the threshold voltage distribution, the distribution width of the threshold voltages of each state may be widened, or the mode value of each state may change. As a result, as illustrated in part (B) of FIG. 8, two adjacent states may overlap each other. In a case where the two adjacent states overlap each other, if the read operation is performed at the read level R(L)def, data different from that at the time of writing is read from a memory cell transistor MT corresponding to the hatched portion in part (B) of FIG. 8. More specifically, in the state S(L-1), read data from a memory cell transistor MT having a threshold voltage equal to or higher than the read level R(L)def results in an error. In addition, in the state S(L), the read data from a memory cell transistor MT having a threshold voltage lower than the read level R(L)def becomes an error. Then, in a case where the number of bits of the erroneous data (the number of fail bits) exceeds the number of correctable error bits of the ECC circuit 13, the ECC circuit 13 cannot correctly decode (correct) the data.
In a case where the number of fail bits is large, the memory controller 1 sets a voltage at which the number of fail bits becomes small as the read level R(L). In part (B) of FIG. 8, the voltage set as the read level R(L) is indicated as a new read level R(L)n. As described above, the shift reading is a read operation performed by setting a voltage obtained by shifting the default read level R(L)def by a certain voltage to the read level R(L).

1.2.2 Vth Tracking Operation

The memory system MS according to the first embodiment searches for a valley position of two adjacent states in the threshold voltage distribution, and executes an operation of determining a read level that minimizes the number of fail bits in a read operation. Hereinafter, the operation is referred to as a Vth tracking operation. In addition, hereinafter, a read level at which the number of fail bits is minimized is also referred to as an optimum read level.

1.2.2.1 Optimum Read Level

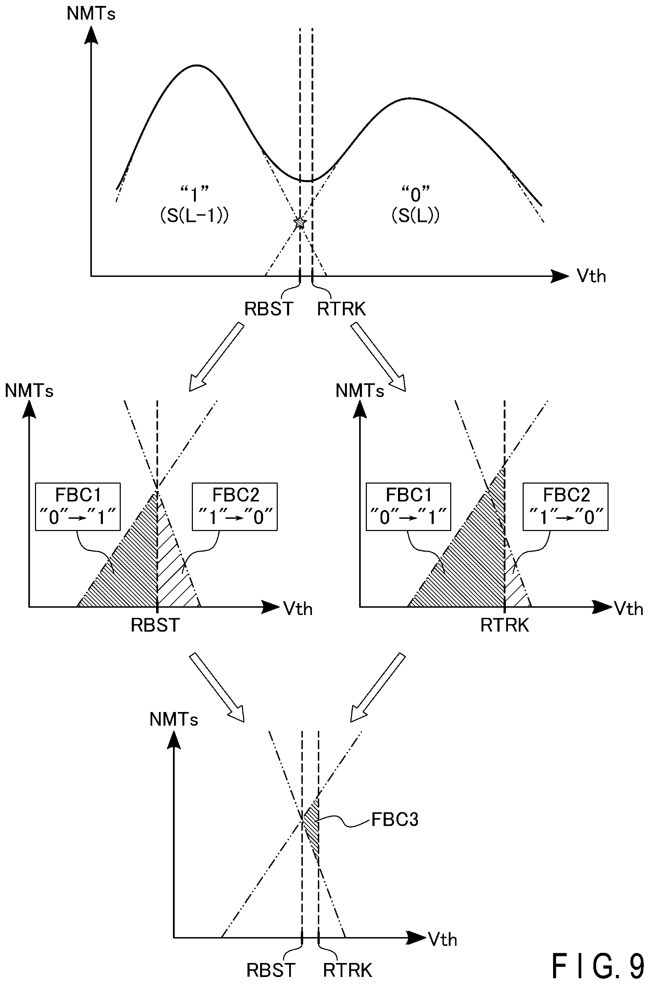

The optimum read level will be described with reference to FIG. 9. FIG. 9 is a schematic diagram for explaining an optimum read level calculated in the memory system according to the first embodiment. FIG. 9 illustrates an example of two adjacent states S(L-1) and S(L) in the threshold voltage distribution in which the threshold voltages of the memory cell transistors MT vary. In FIG. 9, an externally observable distribution of the threshold voltages of the memory cell transistors MT included in the state S(L-1) or S(L) is indicated by the solid line. In addition, the actual distribution of the threshold voltages of the memory cell transistors MT included in each of the states S(L-1) and S(L) is indicated by the one-dot chain line.
In the description of the optimum read level using FIG. 9, it is assumed that, for simplifying the description, each memory cell transistor MT stores one-bit data. In the example of FIG. 9, the states S(L-1) and S(L) are associated with the data "1" and the data "0", respectively, in the ascending order of the threshold voltage. In FIG. 9, the number of memory cell transistors MT in which the written data "0" is erroneously determined as data "1" is indicated as a fail bit number FBC1. In addition, the number of memory cell transistors MT in which the written data "1" is erroneously determined as data "0" is indicated as a fail bit number FBC2.

In order to correct data properly, it is preferable that the number of fail bits (FBC1 + FBC2) is small.

The actual optimum read level RBST (in other words, true optimum read level) at which the number of fail bits is minimum corresponds to an intersection of two adjacent states in the threshold voltage distribution. As the optimum read level RTRK determined by the Vth tracking operation becomes closer to the actual optimum read level RBST, the difference FBC3 (the lower part of FIG. 9) becomes smaller. The difference FBC3 is a difference between the number of fail bits of a case where the read operation is executed using the determined optimum read level RTRK (the right side in the middle part of FIG. 9) and the number of fail bits of a case where the read operation is executed using the actual optimum read level RBST (the left side in the middle part of FIG. 9). The difference FBC3 corresponds to an area of a difference between an area corresponding to the number of fail bits occurring in the read operation using the determined optimum read level RTRK and an area corresponding to the number of fail bits occurring in the read operation using the actual optimum read level RBST.

1.2.2.2 Relationship Between Symmetry of Two Adjacent States and Optimum Read Levels

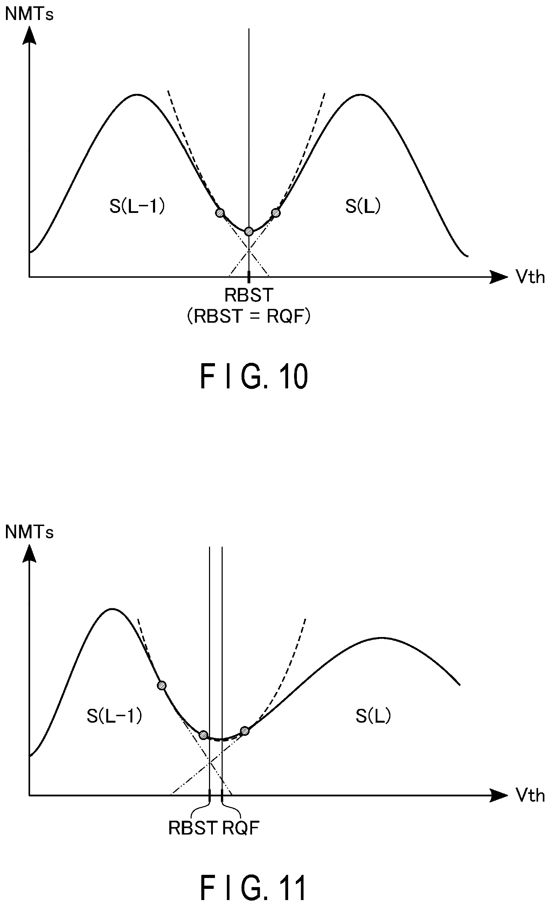

The relationship between the symmetry of the two adjacent states and the optimum read level will be described with reference to FIGS. 10 and 11. FIG. 10 is a schematic diagram illustrating an example of two adjacent states symmetrically distributed in the threshold voltage distribution of the memory system according to the first embodiment. FIG. 11 is a schematic diagram illustrating an example of two adjacent states asymmetrically distributed in the threshold voltage distribution of the memory system according to the first embodiment.

In FIGS. 10 and 11, the externally observable distribution of the threshold voltages of the memory cell transistors MT included in the state S(L-1) or S(L) is indicated by the solid line. The actual distribution of the threshold voltages of the memory cell transistors MT included in each of the states S(L-1) and S(L) is indicated by the one-dot chain line. In FIGS. 10 and 11, three plots are illustrated. Each plot indicates the difference in the number of ON-cells between two adjacent read levels, among read levels set at even intervals in the vicinity of the valley position of the states S(L-1) and S(L). Here, the number of ON-cells is the number of memory cell transistors MT turned on in the read operation using each read level.

In a case where the states S(L-1) and S(L) are symmetrically distributed as illustrated in FIG. 10, the voltage (voltage RQF) is substantially equal to the actual optimum read level RBST. The voltage RQF corresponds to the minimum value of a quadratic function (indicated by a dotted line) which is obtained by fitting the plots of the difference between the numbers of ON-cells.

On the other hand, in a case where the states S(L-1) and S(L) are asymmetrically distributed as illustrated in FIG. 11, the voltage RQF deviates to the high voltage side or the low voltage side with respect to the actual optimum read level RBST. In a case where the deviation between the voltage RQF and the actual optimum read level RBST is large, data read using the voltage RQF may not be properly corrected.

1.2.2.3 Symmetry of Two Adjacent States near Each Valley Position of Threshold Voltage Distribution

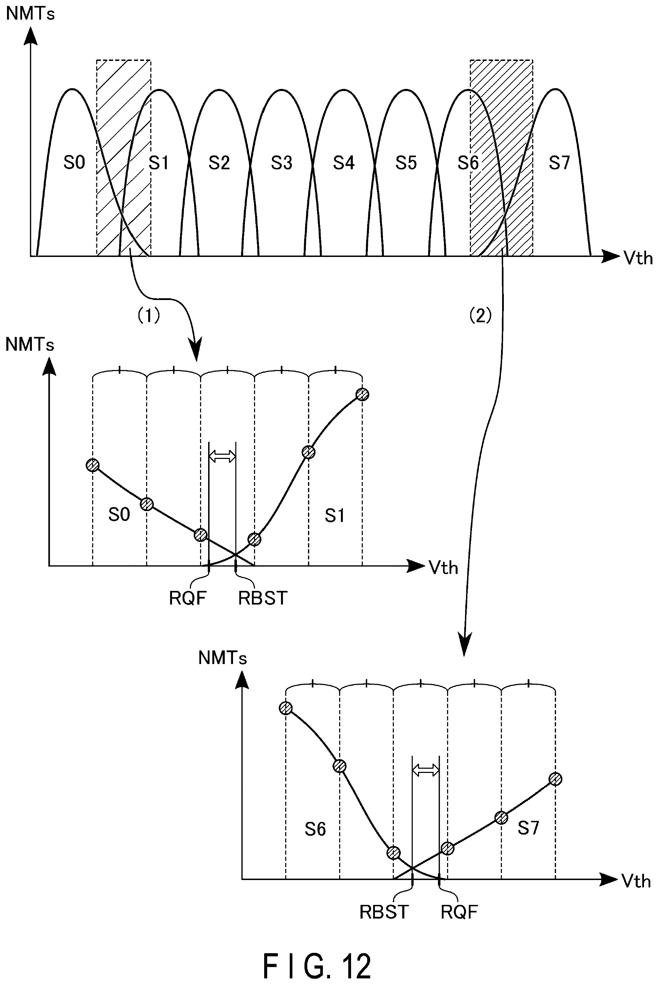

The symmetry of two adjacent states in the vicinity of each valley position of the threshold voltage distribution will be described with reference to FIG. 12. FIG. 12 is a schematic diagram illustrating an example of distribution of varied threshold voltages of the memory cell transistors according to the first embodiment.

In the example illustrated in FIG. 12, the states S1 and S2, the states S2 and S3, the states S3 and S4, the states S4 and S5, and the states S5 and S6 are symmetrically distributed, for example. With this configuration, for the read levels R2 to R6, the voltage RQF becomes substantially equal to the actual optimum read level RBST.

On the other hand, the states S0 and S1, and the states S6 and S7 are asymmetrically distributed, for example. In addition, the states S0 and S7 have a shape wider than each of the states S1 to S6, for example. With this configuration, asymmetry of each of the states S0 and S1, and the states S6 and S7 becomes remarkable.

In (1) of FIG. 12, the vicinity of the valley position of the states S0 and S1 is enlarged. In the example of FIG. 12, in the vicinity, the gradient of the state S0 is smaller than the gradient of the state S1. The gradient is an absolute value of a value obtained by dividing the amount of change in the number of memory cell transistors MT in the threshold voltage distribution by the amount of change in the threshold voltage corresponding to the change in the number. In this case, for example, the voltage RQF deviates to the low voltage side with respect to the actual optimum read level RBST.

In (2) of FIG. 12, the vicinity of the valley position of states S6 and S7 is enlarged. In the example of FIG. 12, in the vicinity, the gradient of the state S7 is smaller than the gradient of the state S6. In this case, for example, the voltage RQF deviates to the high voltage side with respect to the actual optimum read level RBST.

Note that the tendency of asymmetry of adjacent states to occur is the same as above even in a case where each memory cell transistor MT stores two-bit data or data of four-bit or more.

The memory system MS according to the first embodiment is configured to determine the optimum read level RTRK having a small deviation from the actual optimum read level RBST regardless of the symmetry of the two adjacent states in the vicinity of the valley position by the following Vth tracking operation. 1.2.2.4 Overall Procedure of Vth Tracking Operation

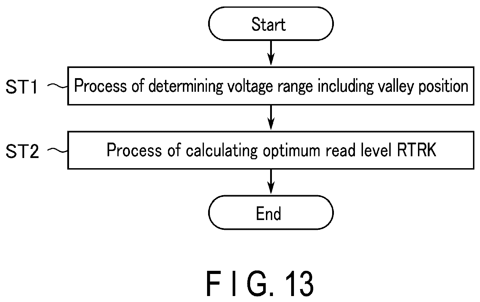

First, the overall procedure of the Vth tracking operation will be described with reference to FIG. 13. FIG. 13 is a flowchart illustrating an example of an outline of the Vth tracking operation executed in the memory system according to the first embodiment.

The memory system MS starts the process illustrated in FIG. 13, for example, in a case where error correction of data read from the memory device 2 fails in a read operation or based on a predetermined schedule (Step "Start").

When the process is started, the memory system MS executes a process of determining a voltage range VRV including the valley position (ST1). In this process, shift reading is performed a plurality of times according to a preset default read level R(L)def. Each shift reading is a read operation in which a shift amount of the voltage from a start read level is designated. The start read level is, for example, the default read level R(L)def. The shift amount is designated by, for example, a digital analog converter (DAC) value. In each of a plurality of times of shift reading in the Vth tracking operation, for example, a plurality of read levels set at even intervals are used. Then, the number of ON-cells at each read level is counted. In addition, a difference in the number of ON-cells between two adjacent read levels is calculated. Hereinafter, a difference in the number of ON-cells between two read levels different from each other is also referred to as a difference bit count. Then, the voltage range VRV including the valley position is determined based on the difference bit count.

In addition, the memory system MS calculates the optimum read level based on the difference bit count and the voltage range VRV including the valley position (ST2). A more specific description of the calculation of the optimum read level will be described later.

As described above, the optimum read level is calculated (Step "End").

1.2.2.5 Process for Determining Voltage Range Including Valley Position

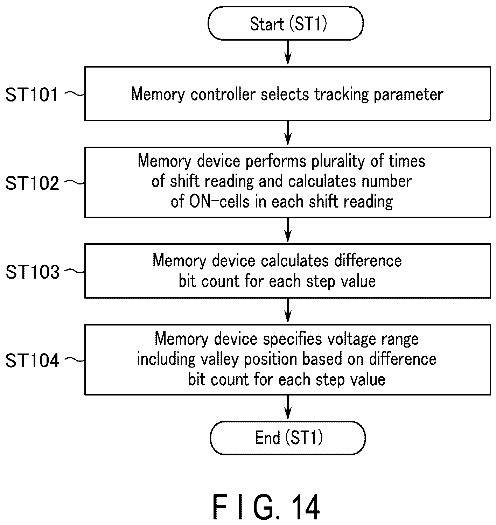

A process for determining the voltage range VRV including the valley position (ST1) will be described with reference to FIG. 14. FIG. 14 is a flowchart for explaining an example of a part of the Vth tracking operation executed in the memory system according to the first embodiment.

When the process of determining the voltage range VRV including the valley position is started (Start (ST1)), the memory controller 1 selects a tracking operation parameter for executing the shift reading plural times based on information related to the threshold voltage distribution of the memory cell transistors MT (ST101). The information related to the threshold voltage distribution of the memory cell transistors MT is, for example, at least one of the type of the adjacent state, the address of the cell unit CU, and information related to the optimum read level obtained by the Vth tracking operation executed in advance. The tracking operation parameter includes settings related to a first read level (start read level) among a plurality of times of shift reading, a voltage between two adjacent read levels (step value) among a plurality of read levels, and the number of times of the shift reading performed multiple times. For example, one value is designated as the step value. In other words, the shift reading is performed a plurality of times using, for example, read levels at even intervals. With such a tracking operation parameter, the shift amount of the voltage from the start read level can be designated for the read level of each shift reading.

Next, the memory device 2 calculates the number of ON-cells in each shift reading of the shift reading performed a plurality of times, based on an instruction from the memory controller 1 (ST102). In the processing of ST102, for example, the memory controller 1 transmits a shift reading command that includes a parameter setting instruction for a read operation and an execution instruction of the read operation, to the memory device 2 in each shift reading. The parameter setting instruction includes information related to a read level used in the shift reading. The memory device 2 executes shift reading based on the shift reading command. In addition, the memory device 2 counts the number of ON-cells by using the read result of the shift reading. The number of ON-cells is counted by, for example, the sequencer 24.

Then, the memory device 2 calculates a difference bit count based on the counted numbers of ON-cells in the shift reading performed the plurality of times (ST103). Each difference bit count calculated in the processing of ST103 is a difference in the numbers of ON-cells at two adjacent read levels among the read levels in the shift reading performed the plurality of times. In the following description, the difference bit count calculated in the processing of ST103 is also referred to as a difference bit count for each step value. The calculation of the difference bit count is executed by the sequencer 24, for example. In the present embodiment, an example in which the difference bit count is calculated in ST103 after the shift reading is performed the plurality of times in ST102 is shown, but the present embodiment is not limited thereto. For example, the calculation of the difference bit count may be executed every time each shift reading is executed.

Then, the memory device 2 specifies the voltage range VRV including the valley position of the target states S(L-1) and S(L) based on the difference bit count for each step value (ST104). For example, the memory device 2 sets a voltage range specified by two read levels corresponding to the smallest difference bit count among the difference bit counts calculated in the processing of ST103, as the voltage range VRV including the valley position.

With the process described above, the process of determining the voltage range VRV including the valley position ends (End (ST1)).

1.2.2.6 Process of Calculating Optimum Read Level

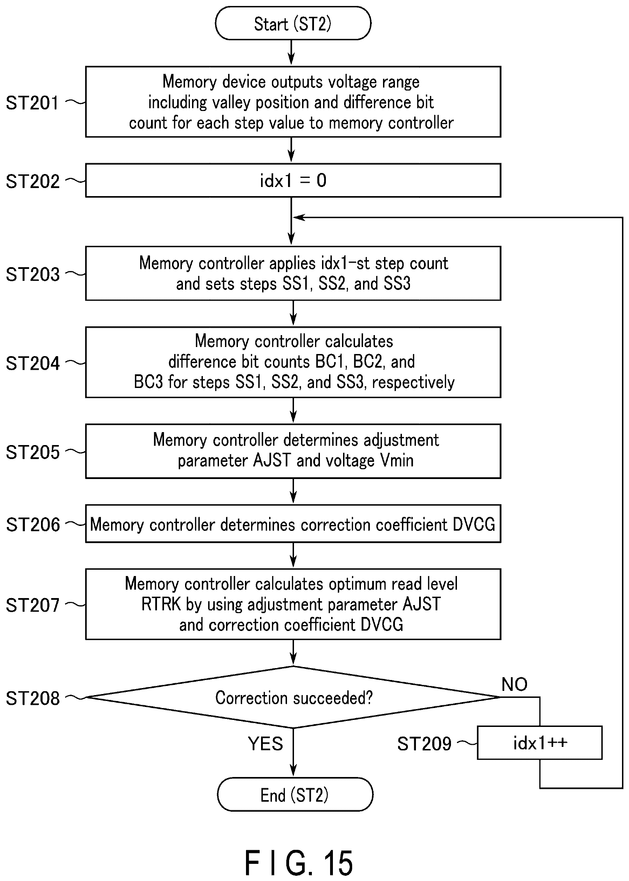

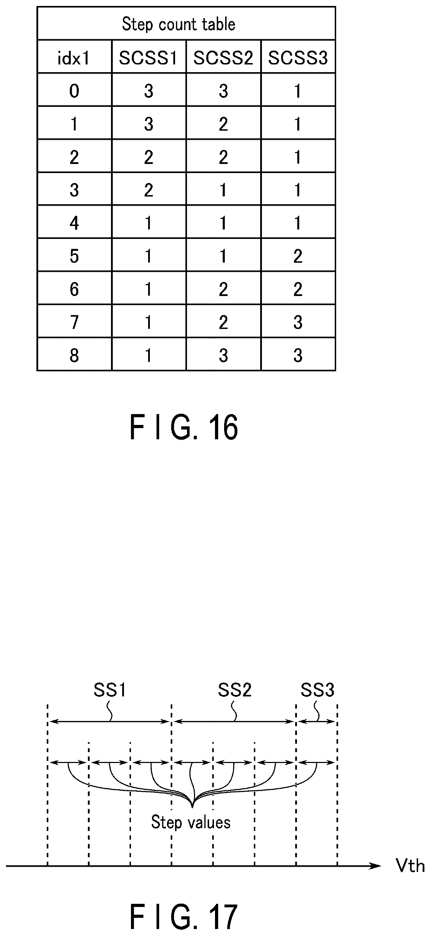

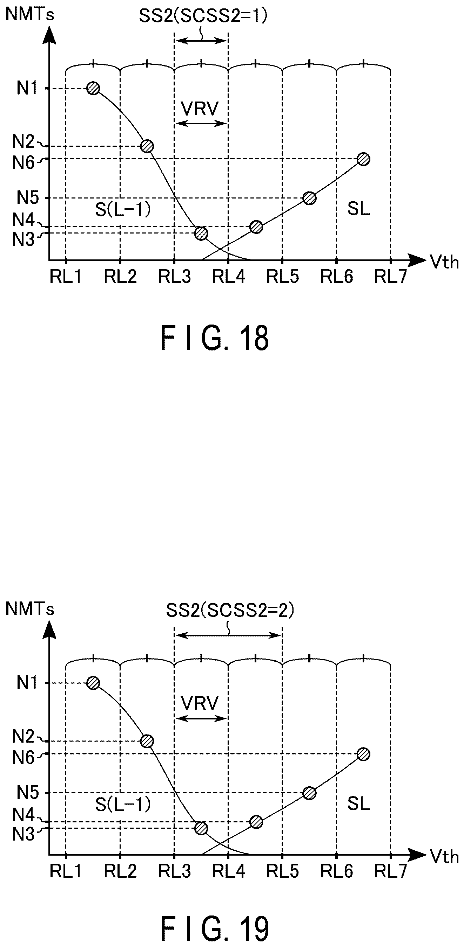

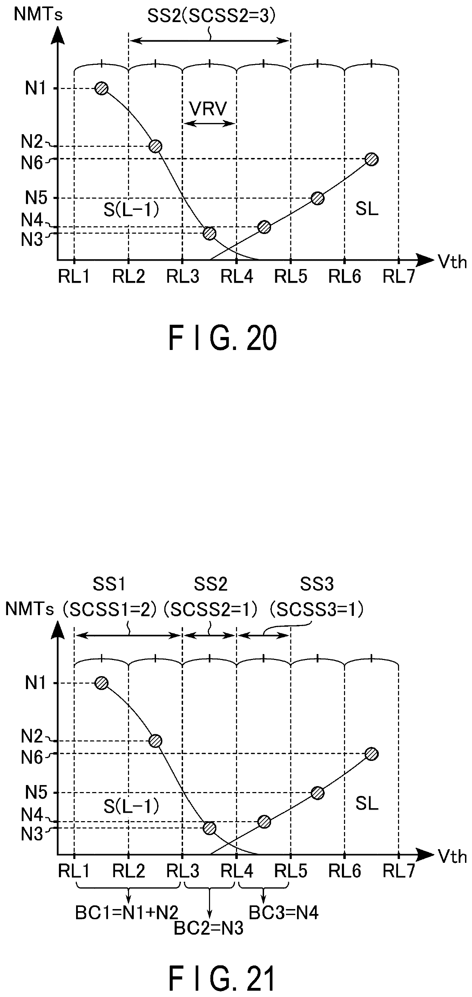

Next, a process of executing the calculation of the optimum read level (ST2) will be described with reference to FIGS. 15 and 16 to 21. FIG. 15 is a flowchart for explaining an example of another part of the Vth tracking operation executed in the memory system according to the first embodiment. FIG. 16 is a diagram illustrating an example of a step count table used in the memory system according to the first embodiment. FIG. 17 is a diagram for explaining an example of steps set in the memory system according to the first embodiment. FIGS. 18 to 20 are diagrams for explaining the relationship between the steps set in the memory system according to the first embodiment and the voltage range including the valley position. FIG. 21 is a diagram for explaining calculation of a difference bit count in each step set in the memory system according to the first embodiment.

As illustrated in FIG. 15, when the process of calculating the optimum read level is started (Start (ST2)), the memory device 2 outputs the voltage range VRV including the valley position calculated in the processing of ST1 and the difference bit count for each step value to the memory controller 1 (ST201).

Next, the memory controller 1 sets an index idx1 to 0 (ST202).

Then, the memory controller 1 sets steps SS1, SS2, and SS3 based on the index idx1 (ST203). As illustrated in FIG. 17, steps SS1, SS2, and SS3 are, for example, voltage ranges that do not overlap each other and are arranged in this order from the low voltage side to the high voltage side. Each of steps SS1, SS2, and SS3 is a voltage range specified by any two read levels of the read levels used for the shift reading performed the plurality of times. Hereinafter, the higher read level of the two read levels specifying each of steps SS1, SS2, and SS3 is simply referred to as an upper limit voltage of the step. In addition, the lower read level of the two read levels specifying each of steps SS1, SS2, and SS3 is simply referred to as a lower limit voltage of the step. The upper limit voltage of step SS1 and the lower limit voltage of step SS2 are, for example, the same. The upper limit voltage of step SS2 and the lower limit voltage of step SS3 are, for example, the same.

The setting of steps SS1, SS2, and SS3 by the memory controller 1 will be described more specifically. The memory controller 1 sets steps SS1, SS2, and SS3 based on the index idx1 and the step count table 141. As illustrated in FIG. 16, the step count table 141 stores indexes idx1 and step counts SCSS1, SCSS2, and SCSS3 corresponding to the indexes idx1. The step counts SCSS1, SCSS2, and SCSS3 correspond to steps SS1, SS2, and SS3, respectively. The memory controller 1 sets the voltage ranges of steps SS1, SS2, and SS3 to voltage ranges obtained by multiplying the step counts SCSS1, SCSS2, and SCSS3 corresponding to the index idx1 by the step value, respectively. The step count table 141 includes various settings of step counts SCSS1, SCSS2, and SCSS3 that symmetrically or asymmetrically designate steps SS1 and SS3 around step SS2.

For example, in a case where the index idx1 is 0, as illustrated in FIG. 16, the step counts SCSS1, SCSS2, and SCSS3 are 3, 3, and 1, respectively. In this case, as illustrated in FIG. 17, step SS1 having a voltage range obtained by multiplying the step value by 3, step SS2 having a voltage range obtained by multiplying the step value by 3, and step SS3 having a voltage range obtained by multiplying the step value by 1 are set to be continuous in this order.

In addition, the memory controller 1 sets the voltage range VRV including the valley position to be included in step SS2. The setting of step SS2 will be described with reference to FIGS. 18 to 20. In FIGS. 18 to 20, read levels RL1 to RL7 are illustrated in the vicinity of the valley position of the states $S(L-1)$ and $S(L)$. The read levels RL1 to RL7 are arranged in the order of the read levels RL1, RL2, RL3, RL4, RL5, RL6, and RL7 for each step value from the low voltage side to the high voltage side (that is, $RL1 < RL2 < RL3 < RL4 < RL5 < RL6 < RL7$). In addition, difference bit counts N1 to N6 respectively corresponding to six consecutive voltage ranges specified by the read levels RL1 to RL7 are illustrated. FIGS. 18 to 20 illustrate examples in which the difference bit counts N1, N2, N6, N5, N4, and N3 are smaller in this order (that is, $N1 > N2 > N6 > N5 > N4 > N3$). The voltage range VRV is a voltage range corresponding to the difference bit count N3.

In a case where the step count SCSS2 is 1, the memory controller 1 sets step SS2 to be in the voltage range VRV including the valley position as illustrated in FIG. 18.

In a case where the step count SCSS2 is 2, for example, as illustrated in FIG. 19, the memory controller 1 sets step SS2 to include a voltage range corresponding to the smaller difference bit count (N4 in the example of FIG. 19) among two difference bit counts (N2 and N4 in the example of FIG. 19) adjacent to the difference bit count having the smallest value (N3 in the example of FIG. 19) calculated in the processing of ST103, in addition to the voltage range VRV including the valley position. In the example of FIG. 19, for example, the memory controller 1 sets step SS2 to include the voltage range VRV corresponding to the difference bit count N3 and the voltage range corresponding to the difference bit count N4.

In a case where the step count SCSS2 is 3, for example, as illustrated in FIG. 20, the memory controller 1 sets such that step SS2 includes, in addition to the voltage range VRV including the valley position, two voltage ranges respectively corresponding to two difference bit counts (N2 and N4 in the example of FIG. 20) adjacent to the difference bit count (N3 in the example of FIG. 20) having the smallest value calculated in the processing of ST103. In the example of FIG. 20, for example, the memory controller 1 sets step SS2 to include the voltage range VRV corresponding to the difference bit count N3 and the two voltage ranges corresponding to the difference bit counts N2 and N4.

The description returns to FIG. 15. The memory controller 1 calculates difference bit counts BC1, BC2, and BC3 in the set steps SS1, SS2, and SS3, respectively (ST204). The memory controller 1 calculates the difference bit counts BC1, BC2, and BC3 by summing the difference bit counts for each step value within the range of each of steps SS1, SS2, and SS3. Each of the difference bit counts BC1, BC2, and BC3 corresponds to a difference in the number of ON-cells in a case where the read operations are performed using the upper limit voltage and the lower limit voltage of the step corresponding to the difference bit count.

As illustrated in FIG. 21, for example, in a case where the index idx1 is 3 and the step counts SCSS1, SCSS2, and SCSS3 are 2, 1, and 1, respectively, the difference bit count BC1 is a value obtained by adding the difference bit counts N1 and N2 (BC1 = N1 + N2). The difference bit count BC2 is the same value as the difference bit count N3 (BC2 = N3). The difference bit count BC3 is the same value as the difference bit count N4 (BC3 = N4).

The description returns to FIG. 15. The memory controller 1 determines an adjustment parameter AJST and a voltage Vmin for calculating the optimum read level based on the calculated difference bit counts BC1, BC2, and BC3 and the voltage range VRV including the valley position (ST205). The determination of the adjustment parameter AJST and the voltage Vmin will be described later.

Next, the memory controller 1 determines a correction coefficient DVCG based on the calculated difference bit counts BC1, BC2, and BC3 (ST206). The determination of the correction coefficient DVCG will be described later.

Then, the memory controller 1 calculates the optimum read level RTRK using the determined adjustment parameter AJST, the voltage Vmin, and the correction coefficient DVCG (ST207). The calculation of the optimum read level RTRK will be described later.

Then, the memory controller 1 determines whether error correction has succeeded (ST208). More specifically, the memory controller 1 causes the memory device 2 to execute a read operation using the calculated optimum read level RTRK. In addition, the ECC circuit 13 performs error detection and error correction process. In a case where it is determined that the error correction has succeeded (ST208; YES), the memory controller 1 acquires a status indicating that the error correction has succeeded, and ends the Vth tracking operation (End ST2). With this process, the optimum read level RTRK is determined. In a case where it is determined that error correction has failed (ST208; NO), the process proceeds to ST209.

In a case where it is determined that error correction has failed (ST208; NO), the memory controller 1 increments the index idx1 (ST209). Then, the processing of ST203 is executed again.

As described above, the settings of the step counts SCSS1, SCSS2, and SCSS3 corresponding to the each of the indexes idx1 of the step count table 141 are applied in order until it is determined that the error correction is successful in the processing of ST208. The memory system MS is configured to be able to determine the optimum read level RTRK having a small deviation from the actual optimum read level RBST by sequentially applying the settings included in the step count table 141 until the error correction succeeds even in a case where the states S(L-1) and S(L) are symmetrically distributed or in a case where these states are asymmetrically distributed.

1.2.2.6.1 Determination of Adjustment Parameter AJST And Voltage Vmin

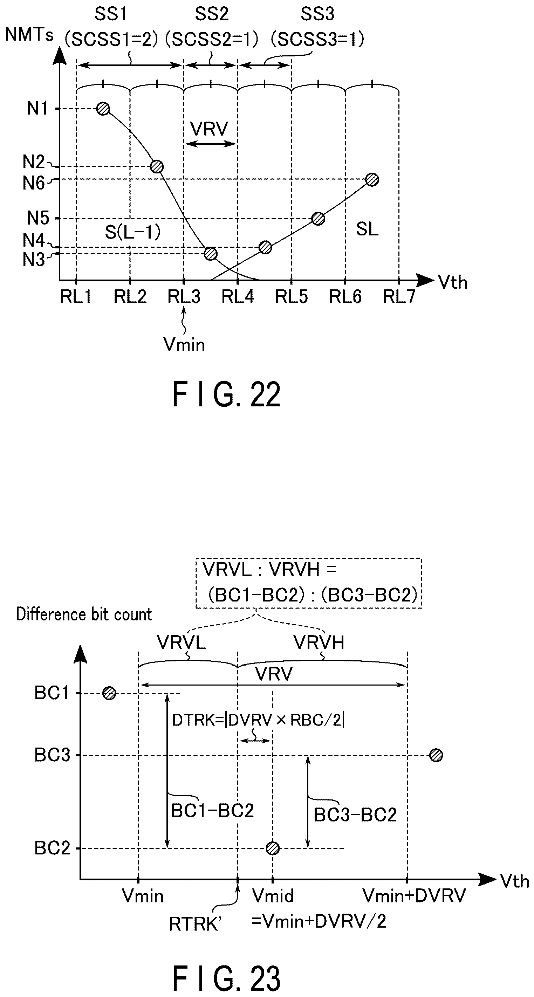

The determination of the adjustment parameter AJST and the voltage Vmin in ST205 will be described with reference to FIGS. 22 to 25.

FIG. 22 is a diagram for explaining a voltage set for calculating an optimum read level in the memory system according to the first embodiment. FIG. 22 illustrates difference bit counts in the vicinity of the valley position of states S(L-1) and S(L). FIG. 22 illustrates a case where the read levels RL1 to RL7 and the difference bit counts N1 to N6 are the same as these values in FIGS. 18 to 21. Furthermore, similarly to FIG. 21, FIG. 22 illustrates a case where the step counts SCSS1, SCSS2, and SCSS3 are 2, 1, and 1, respectively, and the difference bit counts BC1, BC2, and BC3 are BC1=N1+N2, BC2=N3, and BC3=N4, respectively.

In the memory system MS according to the first embodiment, the voltage Vmin is a voltage set for calculating the optimum read level RTRK. For example, the memory controller 1 sets, as the voltage Vmin, the read level on the low voltage side of the two read levels specifying the voltage range VRV including the valley position. In the example of FIG. 22, the voltage range VRV corresponding to the difference bit count N3 having the smallest value is specified by the read levels RL3 and RL4. For example, the memory controller 1 sets the read level RL3 to the voltage Vmin.

FIG. 23 is a diagram for explaining an optimum read level obtained by internal division in the memory system according to the first embodiment. As illustrated in FIG. 23, the memory controller 1 calculates a voltage RTRK' that internally divides the voltage range VRV by a difference (BC1-BC2) and a difference (BC3-BC2). The difference (BC1-BC2) is a difference between the difference bit counts BC1 and BC2, and the difference (BC3-BC2) is a difference between the difference bit counts BC2 and BC3. The voltage RTRK' is used to calculate the optimum read level RTRK.

Specifically, the voltage RTRK' is a voltage such that the ratio of the voltage VRVL to the voltage VRVH (i.e., VRVL:VRVH) is the same as the ratio of the difference (BC1-BC2) to the difference (BC3-BC2) (i.e., (BC1-BC2):(BC3-BC2)). Here, the voltage VRVL is a voltage obtained by subtracting the voltage Vmin from the voltage RTRK'. The voltage VRVH is a voltage obtained by subtracting the voltage RTRK' from the upper limit voltage (i.e., Vmin+DVRV) of the voltage range VRV. The voltage DVRV is a voltage (magnitude) in the voltage range VRV. Specifically, the voltage RTRK' is expressed by using the following Equation (1). The voltage Vmid in the following Equation (1) is expressed using the following Equation (2). The voltage Vmid is a voltage at the center of the voltage range VRV. The value RBC in the following Equation (1) is expressed using the following Equation (3). The value RBC may have a range of, for example, equal to or larger than -1.00 and equal to or smaller than 1.00 (-1.00 ≤ RBC ≤ 1.00).

$$RTRK' = \frac{(BC3 - BC1) \times Vmin + (BC1 - BC2) \times (Vmin + DVRV)}{(BC1 - BC2) + (BC3 - BC2)}$$
$$= Vmid + DVRV \times \left(-\frac{RBC}{2}\right) \qquad (1)$$

$$Vmid = Vmin + \frac{DVRV}{2} \qquad (2)$$

$$RBC = \frac{BC3 - BC1}{BC1 + BC3 - 2 \times BC2} \qquad (3)$$

The differential voltage DTRK between the voltage RTRK' and the voltage Vmid is proportional to the value RBC as shown in the following Equation (4).

$$DTRK = \left|DVRV \times \frac{RBC}{2}\right| \qquad (4)$$

Further, the memory controller 1 calculates, for example, a voltage RTRK'ap which is an approximate value of the above-described voltage RTRK'. The voltage RTRK'ap is expressed by the following Equation (5). In other words, the memory controller 1 approximates the value (-RBC/2) in the above Equation (1) to the adjustment parameter AJST, and calculates the voltage RTRK'ap.

$$RTRK'ap = Vmid + DVRV \times AJST \qquad (5)$$

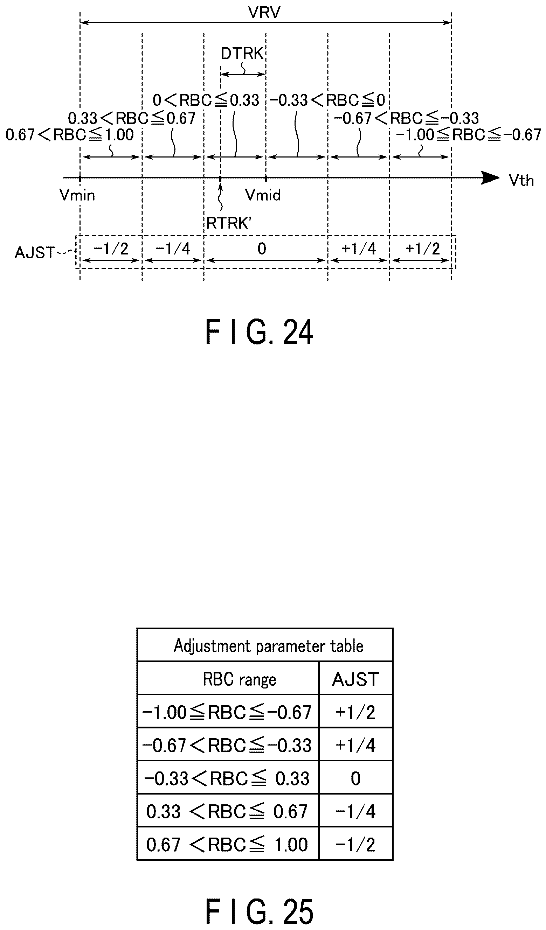

FIG. 24 is a diagram for explaining an example of an adjustment parameter used in the memory system according to the first embodiment. FIG. 25 is a diagram illustrating an example of an adjustment parameter table used in the memory system according to the first embodiment. As illustrated in FIG. 24, the adjustment parameter AJST corresponds to a voltage range including the voltage RTRK'. As illustrated in FIG. 25, the adjustment parameter table 142 stores ranges of the value RBC and the adjustment parameters AJST in association with each other. The memory controller 1 determines the adjustment parameter AJST corresponding to the calculated value RBC based on the value RBC and the adjustment parameter table 142.

More specifically, the memory controller 1 sets the adjustment parameter AJST to -1/2 in a case where the value RBC is larger than 0.67 and equal to or smaller than 1. In this case, BC3 is considerably larger than BC1, and it can be approximated as RTRK'ap = Vmid + DVRV × (-1/2) = Vmin. Note that, for example, in a case where the difference (BC3-BC2) is equal to or larger than five times the difference (BC1-BC2), the value RBC is larger than 0.67 and equal to or smaller than 1.

In a case where the value RBC is larger than 0.33 and equal to or smaller than 0.67, the memory controller 1 sets the adjustment parameter AJST to -1/4. In this case, BC3 is larger than BC1, and it can be approximated as RTRK'ap = Vmid + DVRV × (-1/4). Note that, for example, in a case where the difference (BC3-BC2) is equal to or larger than two times and smaller than five times the difference (BC1-BC2), the value RBC is larger than 0.33 and equal to or smaller than 0.67.

The memory controller 1 sets the adjustment parameter AJST to 0 in a case where the value RBC is larger than -0.33 and equal to or smaller than 0.33. In this case, BC3 is comparable to BC1 and it can be approximated as RTRK'ap = Vmid + DVRV × 0 = Vmid. Note that, for example, in a case where the difference (BC3-BC2) is equal to or larger than 0.5 times and smaller than two times the difference (BC1-BC2), the value RBC is larger than -0.33 and equal to or smaller than 0.33.

In a case where the value RBC is larger than -0.67 and equal to or smaller than -0.33, the memory controller 1 sets the adjustment parameter AJST to +1/4. In this case, BC1 is larger than BC3, and it can be approximated as RTRK'ap = Vmid + DVRV × (+1/4). Note that, for example, in a case where the difference (BC1-BC2) is equal to or larger than two times and smaller than five times the difference (BC3-BC2), the value RBC is larger than -0.67 and equal to or smaller than -0.33.

In a case where the value RBC is equal to or larger than -1 and equal to or smaller than -0.67, the memory controller 1 sets the adjustment parameter AJST to +1/2. In this case, BC1 is considerably larger than BC3, and it can be approximated as RTRK'ap = Vmid + DVRV $\times$ (+1/2). Note that, for example, in a case where the difference (BC1-BC2) is equal to or larger than five times the difference (BC3-BC2), the value RBC is equal to or larger than -1 and equal to or smaller than -0.67.

The adjustment parameter AJST is determined as described above. As described later, the memory controller 1 can calculate the optimum read level RTRK using the adjustment parameter AJST.

1.2.2.6.2 Determination of Correction Coefficient DVCG

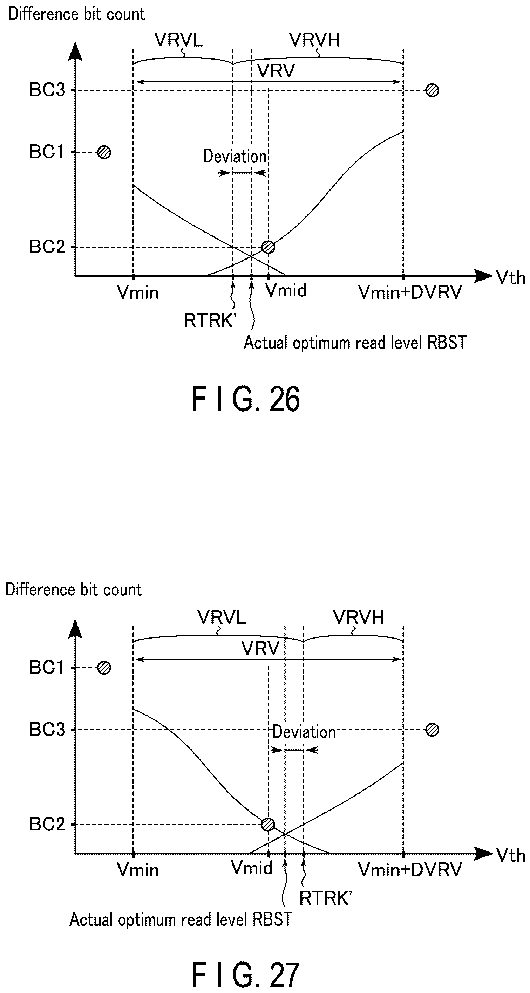

The determination of the correction coefficient DVCG in ST206 will be described with reference to FIGS. 26 to 31. FIGS. 26 and 27 are diagrams for explaining an example of the deviation between the actual optimum read level and the voltage obtained by the internal division in the memory system according to the first embodiment.

In a case where the states S(L-1) and S(L) are symmetrically distributed, the deviation between the actual optimum read level and the voltage obtained by the internal division tends to be small. However, in a case where the states S(L-1) and S(L) are asymmetrically distributed, the deviation between the voltage obtained by the internal component and the actual optimum read level tends to increase. For example, in a case where the gradient of the state S(L-1) is smaller than the gradient of the state S(L), the voltage RTRK' (and the voltage RTRK'ap approximate thereto) tends to be located on the low voltage side with respect to the actual optimum read level RBST as illustrated in FIG. 26. Furthermore, for example, in a case where the gradient of the state S(L) is smaller than the gradient of the state S(L-1), the voltage RTRK' (and the voltage RTRK'ap approximate thereto) tends to be located on the high voltage side with respect to the actual optimum read level RBST as illustrated in FIG. 27.

Therefore, the memory controller 1 calculates, as the optimum read level RTRK, a value obtained by adjusting the voltage RTRK'ap based on, for example, a target read level and the difference bit counts BC1 and BC3. For example, the memory controller 1 calculates the optimum read level RTRK based on the following Equation (6). In other words, the memory controller 1 calculates, as the optimum read level RTRK, a voltage obtained by multiplying the voltage RTRK'ap by a correction coefficient C1. As shown in the following Equation (6), the voltage obtained by multiplying the voltage RTRK'ap by the correction coefficient C1 can be expressed as a value obtained by adding a value (DVRV$\times$AJST$\times$C2), which is obtained by multiplying the voltage DVRV by the adjustment parameter AJST and a correction coefficient C2 to the voltage Vmid. The correction coefficient DVCG in the following Equation (6) is a value (DVRV$\times$C2). In other words, the correction coefficient DVCG is a coefficient for correcting the above-described deviation.

$$\begin{aligned} \text{RTRK} = \text{RTRK'ap} \times \text{C1} &= (\text{Vmid} + \text{DVRV} \times \text{AJST}) \times \text{C1} \\ &= \text{Vmid} + \text{DVRV} \times \text{AJST} \times \text{C2} \\ &= \text{Vmid} + \text{DVCG} \times \text{AJST} \qquad (6) \end{aligned}$$

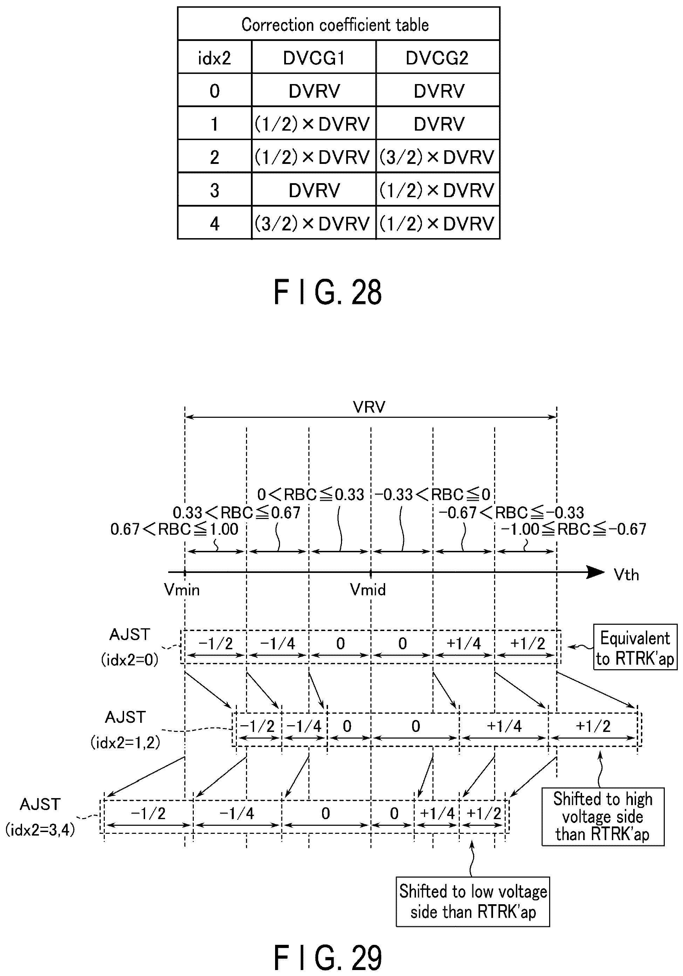

The correction coefficient DVCG will be described. FIG. 28 is a diagram illustrating an example of a correction coefficient table used in the memory system according to the first embodiment. FIG. 29 is a diagram for explaining an example of correction coefficients used in the memory system according to the first embodiment.

As illustrated in FIG. 28, the correction coefficient table 143 stores indexes idx2 and the correction coefficients DVCG1 and DVCG2 corresponding to the indexes idx2. The memory controller 1 determines the correction coefficient DVCG for each index idx2 based on the magnitude relationship between the difference bit counts BC1 and BC3. Specifically, for example, in a case where the difference bit count BC1 is equal to or smaller than the difference bit count BC3 (in a case where BC1 $\leq$ BC3), the memory controller 1 applies the correction coefficient DVCG1 as the correction coefficient DVCG. In a case where the difference bit count BC1 is larger than the difference bit count BC3 (in a case where BC1 > BC3), the memory controller 1 applies the correction coefficient DVCG2 as the correction coefficient DVCG.

In a case where the index idx2 is 0, the memory controller 1 selects the voltage DVRV as the correction coefficient DVCG regardless of the difference bit counts BC1 and BC3. In this case, the Equation (6) and the Equation (5) become identical, and as illustrated in FIG. 29, the possible voltage range of the optimum read level RTRK becomes equal to the possible voltage range of the voltage RTRK'ap.

In a case where the index idx2 is 1 or 2, the memory controller 1 determines the correction coefficient DVCG according to the difference bit counts BC1 and BC3. Specifically, in a case where BC1 $\leq$ BC3, the memory controller 1 selects, as the correction coefficient DVCG, the correction coefficient DVCG1 smaller than the voltage DVRV. In a case where BC1 > BC3, the memory controller 1 selects, as the correction coefficient DVCG, the correction coefficient DVCG2 that is equal to or larger than the voltage DVRV. In this case, as illustrated in FIG. 29, in the voltage range that is equal to or lower than the voltage Vmid, the possible voltage range of the optimum read level RTRK becomes narrower on the high voltage side than the possible voltage range of the voltage RTRK'ap. In addition, in the voltage range that is higher than the voltage Vmid, the possible voltage range of the optimum read level RTRK is wider on the high voltage side than the possible voltage range of the voltage RTRK'ap.

In a case where the index idx2 is 3 or 4, the memory controller 1 determines the correction coefficient DVCG according to the difference bit counts BC1 and BC3. Specifically, in a case where BC1 $\leq$ BC3, the memory controller 1 selects, as the correction coefficient DVCG, the correction coefficient DVCG1 that is equal to or larger than the voltage DVRV. In a case where BC1 > BC3, the memory controller 1 selects the correction coefficient DVCG2 smaller than the voltage DVRV. In this case, as illustrated in FIG. 29, in the voltage range that is equal to or lower than the voltage Vmid, the possible voltage range of the optimum read level RTRK is wider on the low voltage side than the possible voltage range of the voltage RTRK'ap. In addition, in the voltage range that is higher than the voltage Vmid, the possible voltage range of the optimum read level RTRK becomes narrower on the low voltage side than the possible voltage range of the voltage RTRK'ap.

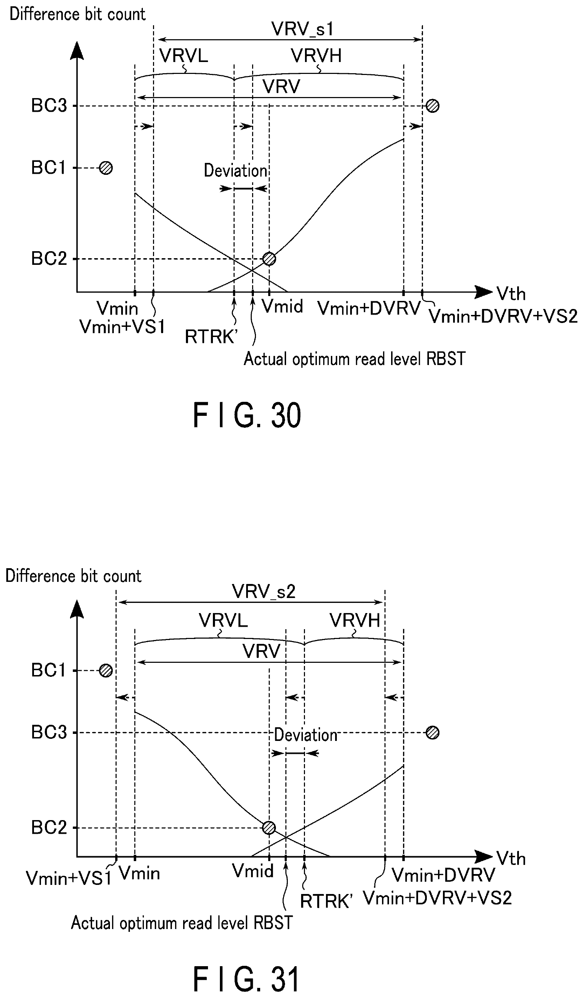

In ST206, for example, the memory controller 1 determines the index idx2 according to the target read level, and determines the correction coefficient DVCG based on the difference bit counts BC1 and BC3. The index idx2 according to the target read level and the correction coefficients DVCG1 and DVCG2 corresponding to the index idx2 will be described. FIGS. 30 and 31 are diagrams for explaining the optimum read level calculated in consideration of the deviation in the memory system according to the first embodiment.

For example, in a case where the states S(L-1) and S(L) are expected to be symmetrically distributed, the memory controller 1 sets the index idx2 to 0. For example, in a case where the read level R3, R4, or R5 is a target, the memory controller 1 sets the index idx2 to 0. In this case, as described above, the optimum read level RTRK is equal to the voltage RTRK'ap expressed by the above Equation (5).

Furthermore, for example, in a case where the states S(L-1) and S(L) are expected to be asymmetrically distributed and the gradient of the state S(L-1) is smaller than the gradient of the state S(L), the memory controller 1 sets the index idx2 to 1 or 2. For example, the memory controller 1 sets the index idx2 to 2 in a case where the read level R1 is a target, and sets the index idx2 to 1 in a case where the read level R2 is a target. In this case, as described above, the optimum read level RTRK shifts to the high voltage side with respect to the voltage RTRK'ap.

In this case, as illustrated in FIG. 30, the possible voltage range of the optimum read level RTRK is shifted from the voltage range VRV to a higher voltage range VRV_s1. The lower limit voltage of the voltage range VRV_s1 is a voltage (Vmin+VS1). The upper limit voltage of the voltage range VRV_s1 is a voltage (Vmin+DVRV+VS2). The voltage VS1 is expressed by the following Equation (7). The voltage VS2 is expressed by the following Equation (8).

$$VS1 = \frac{VRV}{2} \times \left(1 - \frac{DVCG1}{VRV}\right) \qquad (7)$$

$$VS2 = \frac{VRV}{2} \times \left(\frac{DVCG2}{VRV} - 1\right) \qquad (8)$$

More specifically, in a case where BC1 $\leq$ BC3, the memory controller 1 selects (1/2)$\times$DVRV as the correction coefficient DVCG. In a case where BC1 > BC3, the memory controller 1 selects DVRV (for idx2=1) or (3/2)$\times$DVRV (for idx2=2) as the correction coefficient DVCG. As described above, in the voltage range that is higher than the voltage Vmid, in a case where the index idx2 is 2, the possible voltage range of the optimum read level RTRK can be widened to the high voltage side as compared with a case where the index idx2 is 1.

Furthermore, for example, in a case where the states S(L-1) and S(L) are expected to be asymmetrically distributed and the gradient of the state S(L-1) is larger than the gradient of the state S(L), the memory controller 1 sets the index idx2 to 3 or 4. For example, the memory controller 1 sets the index idx2 to 3 in a case where the read level R6 is a target, and sets the index idx2 to 4 in a case where the read level R7 is a target. In this case, as described above, the optimum read level RTRK shifts to the low voltage side with respect to the voltage RTRK'ap.

In this case, as illustrated in FIG. 31, the possible voltage range of the optimum read level RTRK is shifted from the voltage range VRV to a lower voltage range VRV_s2. The lower limit voltage and the upper limit voltage of the voltage range VRV_s2 are equivalent to Equation (7) and Equation (8), respectively.

More specifically, in a case where BC1 $\leq$ BC3, the memory controller 1 selects DVRV (for idx2=3) or (3/2)$\times$DVRV(for idx2=4) as the correction coefficient DVCG. In a case where BC1 > BC3, the memory controller 1 selects (1/2)$\times$DVRV as the correction coefficient DVCG. As described above, in the voltage range lower than the voltage Vmid, in a case where the index idx2 is 4, the possible voltage range of the optimum read level RTRK is widened to the low voltage side as compared with a case where the index idx2 is 3.

Note that, in the above example, a case where the memory controller 1 applies the predetermined index idx2 according to the target read level has been described, but the present embodiment is not limited thereto. For example, the memory controller 1 may determine the index idx2 to be applied based on information of the threshold voltage distribution acquired so far. For example, in a case where the gradient of the state S(L-1) is smaller than the gradient of the state S(L), the memory controller 1 can set the index idx2 to 1 or 2 according to the degree of asymmetry of the states S(L-1) and S(L). Furthermore, for example, in a case where the gradient of the state S(L-1) is larger than the gradient of the state S(L), the memory controller 1 can set the index idx2 to 3 or 4 according to the degree of asymmetry of the states S(L-1) and S(L).

As described above, for example, by applying the correction coefficient DVCG determined based on the target read level and the magnitude relationship between the difference bit counts BC1 and BC3, the memory controller 1 can calculate the optimum read level RTRK so as to eliminate or reduce the deviation between the voltage RTRK' (or the voltage RTRK'ap approximate thereto) obtained by the internal component and the actual optimum read level RBST.

1.2.2.6.3 Calculation of Optimum Read Level RTRK

The calculation of the optimum read level RTRK in ST207 will be described.

The memory controller 1 calculates the optimum read level RTRK using the adjustment parameter AJST, the voltage Vmin, and the correction coefficient DVCG determined in the processing of ST205 and ST206. The memory controller 1 calculates the optimum read level RTRK using the above Equation (6).

It is determined whether or not the error correction is successful based on the shift reading executed using the optimum read level RTRK calculated as described above.

1.3 Technical Advantages

According to the first embodiment, a decrease in reliability of the memory system MS can be reduced and the operation speed can be improved. This effect will be described below.

The memory system MS according to the first embodiment includes the memory controller 1 and the memory device 2. In the tracking operation of calculating the optimum read level RTRK between the states S(L-1) and S(L), the memory controller 1 causes the memory device 2 to execute shift reading a plurality of times using a plurality of read levels in which step values at even intervals are set, in the vicinity of valley position between these states. In addition, the memory device 2 calculates a plurality of difference bit counts by using the number of ON-cells, which are memory cells to be turned on among the memory cells, acquired in each of the read operations. The memory controller 1 sequentially applies the settings included in the step count table 141. The memory controller 1 calculates difference bit counts BC1, BC2, and BC3 in steps SS1, SS2, and SS3 corresponding to the applied settings by using the difference bit counts calculated by the memory device 2. The step count table 141 includes settings in which steps SS1 and SS3 have asymmetric magnitudes around step SS2. In addition, the memory controller 1 calculates the optimum read level RTRK using the difference bit count calculated in each of steps SS1, SS2, and SS3. With the above configuration, the memory system MS according to the first embodiment can determine the optimum read level RTRK between the asymmetrically distributed states S(L-1) and S(L) with high accuracy while preventing an increase in the number of times of performing the shift reading. Therefore, with the memory system MS according to the first embodiment, a decrease in reliability of the memory system MS can be prevented and the operation speed can be improved.

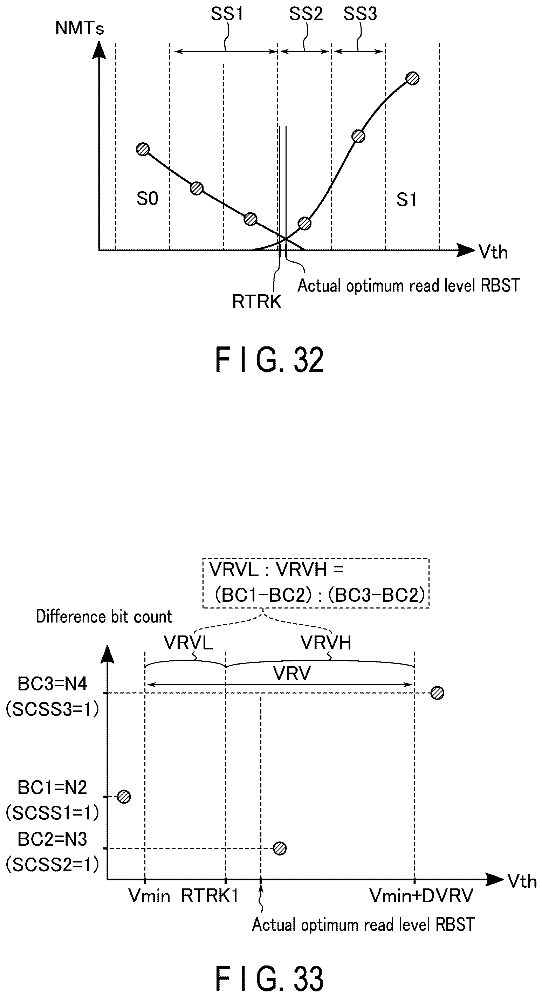

The effect according to the first embodiment will be described with reference to FIGS. 32 to 37.

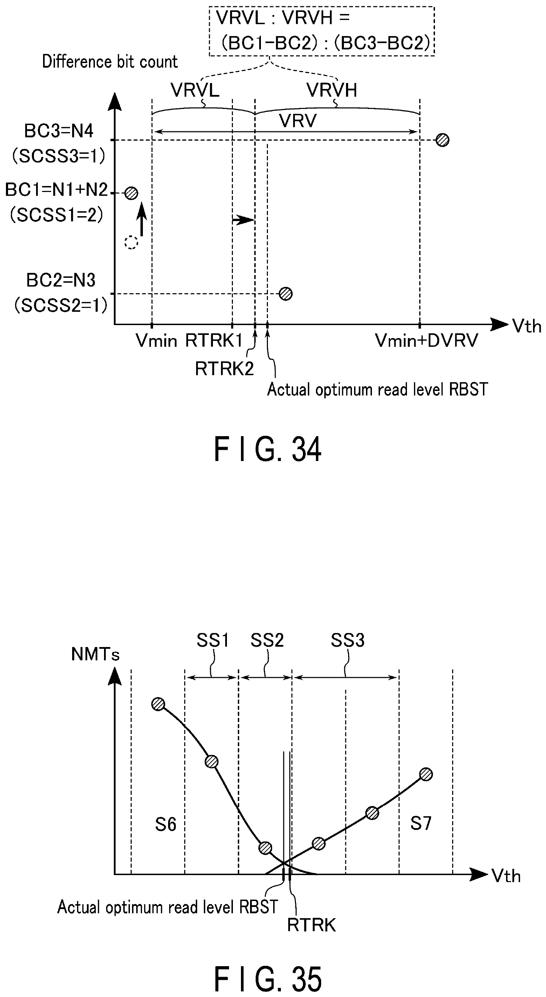

FIG. 32 is a schematic diagram for explaining an example of calculation of the optimum read level in the Vth tracking operation executed in the memory system according to the first embodiment. FIG. 32 illustrates an example of the calculation of the optimum read level RTRK for the states S0 and S1. In FIG. 32, the read levels used in the shift reading in the processing of ST1 are indicated by the dotted lines. FIGS. 33 and 34 are diagrams for explaining examples of reducing the deviation between the calculated optimum read level and the actual optimum read level in the memory system according to the first embodiment.

As illustrated in FIG. 32, in the vicinity of the valley position of the states S0 and S1, the gradient of the state S0 is smaller than the gradient of the state S1. As described above, in a case where the gradient of the state S(L-1) is smaller than the gradient of the state S(L) in the vicinity of the valley position of the states S(L-1) and S(L), the memory controller 1 can bring the optimum read level RTRK close to the actual optimum read level RBST by making the size of step SS1 larger than the size of step SS3.

FIG. 33 illustrates an example of a case where the step counts SCSS1, SCSS2, and SCSS3 are all 1, and the difference bit counts BC1, BC2, and BC3 are set to N2, N3, and N4, respectively. In addition, the calculated optimum read level RTRK is indicated as an optimum read level RTRK1. In such a case, as illustrated in FIG. 33, the calculated optimum read level RTRK1 tends to be located on the low voltage side with respect to the actual optimum read level RBST.

On the other hand, as illustrated in FIG. 34, by making the step count SCSS1 on the state S(L-1) side, which has a smaller gradient out of the states S(L-1) and S(L), be larger than the step count SCSS3, weighting can be performed such that the influence of the difference bit count BC1 corresponding to step SS1 increases. FIG. 34 illustrates an example in which the step counts SCSS1, SCSS2, and SCSS3 are 2, 1, and 1, respectively, and the difference bit counts BC1, BC2, and BC3 are set to (N1+N2), N3, and N4, respectively. In addition, the calculated optimum read level RTRK is indicated as an optimum read level RTRK2. In the example of FIG. 34, by setting the step count SCSS1 to 2 and setting the difference bit count BC1 to (N1+N2), the difference bit count BC1 increases as compared with the example of FIG. 33. As a result, the calculated optimum read level RTRK2 is shifted to a higher voltage side than the optimum read level RTRK1. In other words, as compared with the example of FIG. 33, the deviation between the calculated optimum read level RTRK and the actual optimum read level RBST can be reduced.

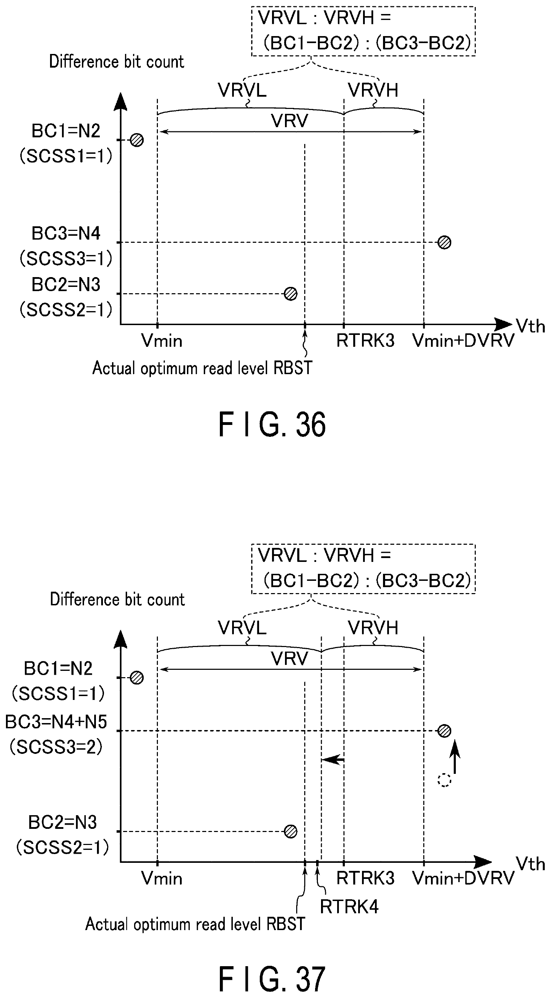

FIG. 35 is a schematic diagram for explaining another example of the calculation of the optimum read level in the Vth tracking operation executed in the memory system according to the first embodiment. FIG. 35 illustrates an example of the calculation of the optimum read level RTRK for the states S6 and S7. In FIG. 35, the read levels used in the shift reading in the processing of ST1 are indicated by the dotted lines. FIGS. 36 and 37 are diagrams for explaining examples of reducing the deviation between the calculated optimum read level and the actual optimum read level in the memory system according to the first embodiment.

As illustrated in FIG. 35, in the vicinity of the valley position of states S6 and S7, the gradient of state S6 is larger than the gradient of state S7. As described above, in a case where the gradient of the state S(L-1) is larger than the gradient of the state S(L) in the vicinity of the valley position of the states S(L-1) and S(L), the memory controller 1 can bring the optimum read level RTRK close to the actual optimum read level RBST by making the size of step SS1 smaller than the size of step SS3.

In a case where the asymmetry of the states S(L-1) and S(L) becomes remarkable and, for example, the gradient of the state S(L-1) around the valley position is larger than the gradient of the state S(L), if the step counts SCSS1, SCSS2, and SCSS3 are set to the same value, the voltage Vmid tends to be lower than the midpoint. In such a case, for example, the actual optimum read level RBST may be located on a lower voltage side than the possible voltage range of the optimum read level RTRK in a case where the value RBC is larger than -0.33 and equal to or smaller than 0.33. Furthermore, in such a case, as illustrated in FIG. 36, the calculated optimum read level RTRK tends to be located on the high voltage side with respect to the actual optimum read level RBST. FIG. 36 illustrates an example of a case where the step counts SCSS1, SCSS2, and SCSS3 are all 1, and the difference bit counts BC1, BC2, and BC3 are N2, N3, and N4, respectively. In addition, the calculated optimum read level RTRK is indicated as an optimum read level RTRK3.

In such a case, as illustrated in FIG. 37, by making the step count SCSS3 on the state S(L) side, which has a smaller gradient among the states S(L-1) and S(L), be larger than the step count SCSS1, weighting can be performed such that the influence of the difference bit count BC3 corresponding to step SS3 increases. FIG. 37 illustrates an example in which the step counts SCSS1, SCSS2, and SCSS3 are 1, 1, and 2, respectively, and the difference bit counts BC1, BC2, and BC3 are N2, N3, and (N4+N5), respectively. In addition, the calculated optimum read level RTRK is indicated as an optimum read level RTRK4. In the example of FIG. 37, by setting the step count SCSS3 to 2 and setting the difference bit count BC3 to the difference bit count (N4+N5), the difference bit count BC3 increases as compared with the example of FIG. 36. As a result, the calculated optimum read level RTRK4 shifts to a lower voltage side than the optimum read level RTRK3. In other words, as compared with the example of FIG. 36, the deviation between the calculated optimum read level RTRK and the actual optimum read level RBST can be reduced.

According to the first embodiment, even in a case where the gradient of the state S(L-1) around the valley position is smaller than the gradient of the state S(L) or in a case where the gradient of the state S(L-1) around the valley position is larger than the gradient of the state S(L), the optimum read level RTRK can be brought close to the actual optimum read level RBST by sequentially applying the settings of the step counts SCSS1, SCSS2, and SCSS3 corresponding to each index idx1.

In other words, in a case where these states are asymmetrically distributed in the vicinity of the valley position of the states S(L-1) and S(L), it is possible to improve the accuracy of the calculation of the optimum read level RTRK by asymmetrically setting step SS1 and step SS3. According to the first embodiment, the settings of the step counts SCSS1, SCSS2, and SCSS3 corresponding to the respective indexes idx1 of the step count table 141 are applied in order until it is determined in ST208 that the error correction is successful. In other words, the symmetrical or asymmetrical setting of steps SS1 and SS3 is applied in order. With the above configuration, according to the first embodiment, the optimum read level RTRK can be determined with high accuracy regardless of the symmetry of the distributions of the states S(L-1) and S(L).

Furthermore, according to the first embodiment, the results of the shift reading executed in the processing of ST1 are used in calculating the bit count in each of steps SS1, SS2, and SS3 for calculating the optimum read level RTRK. In other words, after determining the voltage range including the valley position of the states S(L-1) and S(L), the memory system MS can calculate the difference bit counts BC1, BC2, and BC3 in steps SS1, SS2, and SS3, respectively, without newly performing shift reading, using the upper limit voltage and the lower limit voltage of each step for determining the optimum read level. As a result, the operation speed can be improved.

As described above, the memory system MS according to the first embodiment can prevent a decrease in reliability of the memory system MS and improve the operation speed.

2 Further embodiments of First Embodiment

The above-described first embodiment can be variously modified. Hereinafter, a memory system according to further embodiments of the first embodiment will be described.

2.1 First Further embodiment of First Embodiment

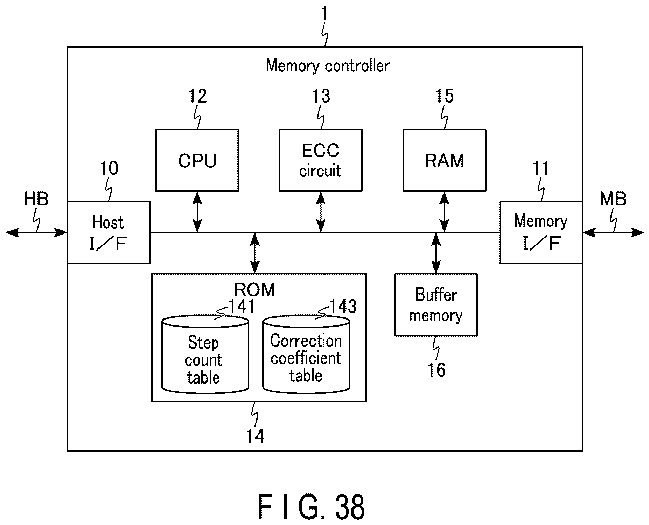

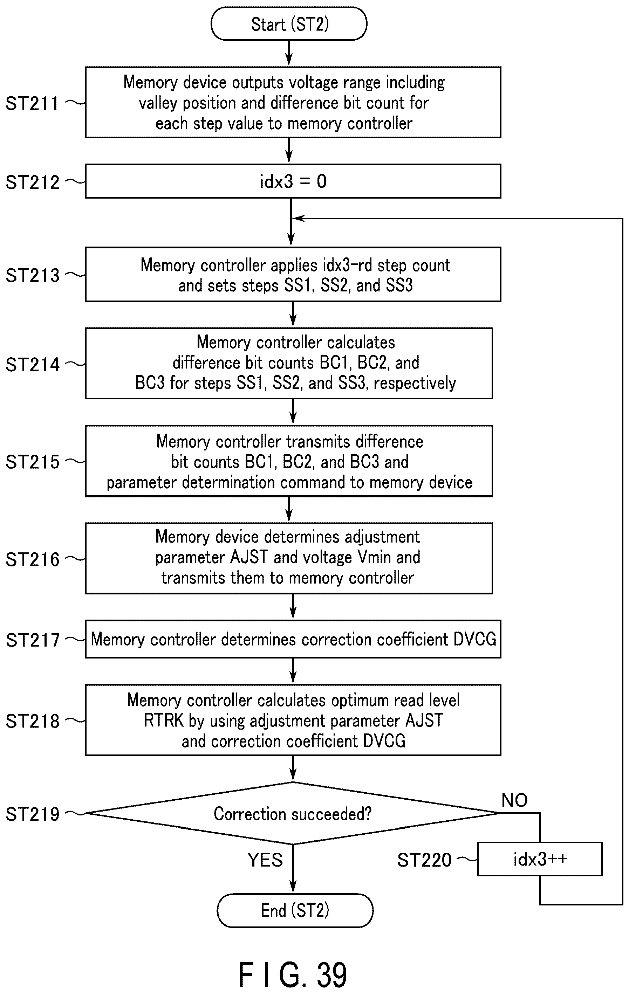

In the first embodiment, the case where the memory controller 1 determines the adjustment parameter AJST and the voltage Vmin has been described, but the present embodiment is not limited thereto. The adjustment parameter AJST and the voltage Vmin may be determined by the memory device 2.
A configuration of a memory system MS according to a first further embodiment of the first embodiment will be described with reference to FIG. 38. FIG. 38 is a block diagram illustrating an example of a hardware configuration of a memory controller included in the memory system according to the first further embodiment of the first embodiment.
In the first further embodiment of the first embodiment, a ROM 14 of a memory controller 1 stores, for example, a program such as firmware and management data. The management data is, for example, various tables including a step count table 141. In the first further embodiment of the first embodiment, an adjustment parameter table is stored in a memory device 2 instead of the ROM 14. Although not illustrated, the adjustment parameter table may be stored in a memory cell array 20 or may be stored in another storage element in the memory device 2. Other configurations are substantially equivalent to the configuration of the memory system according to the first embodiment.
Next, a Vth tracking operation according to the first further embodiment of the first embodiment will be described with reference to FIG. 39. FIG. 39 is a flowchart for explaining an example of a part of the Vth tracking operation executed in the memory system according to the first further embodiment of the first embodiment. In the Vth tracking operation according to the first further embodiment of the first embodiment, the overall procedure and the process of determining a voltage range VRV including a valley position may be equivalent to the Vth tracking operation according to the first embodiment, and thus the description thereof will be omitted. Hereinafter, the process of calculating the optimum read level RTRK (ST2) will be mainly described.
The processing of ST211 is equivalent to the processing of ST201.
The processing of ST212 and ST213 is similar to the processing of ST202 and ST203, respectively, except that the index idx3 is used instead of the index idx1. In the first further embodiment of the first embodiment, instead of the index idx1, the step count table 141 stores indexes idx3 and step counts SCSS1, SCSS2, and SCSS3 corresponding to the indexes idx3.
The processing of ST214 is equivalent to the processing of ST204.
The memory controller 1 transmits difference bit counts BC1, BC2, and BC3 calculated in ST214 and a parameter determination command to the memory device 2 (ST215). The parameter determination command is a command for causing the memory device 2 to determine an adjustment parameter AJST and a voltage Vmin.
Next, the memory device 2 determines the adjustment parameter AJST and the voltage Vmin based on the difference bit counts BC1, BC2, and BC3 and the parameter determination command transmitted from the memory controller 1, and transmits the determined adjustment parameter AJST and voltage Vmin to the memory controller 1 (ST216). The memory device 2 determines the adjustment parameter AJST similarly to the first embodiment except that the adjustment parameter table stored in the memory device 2 is used. In addition, the memory device 2 determines the voltage Vmin based on a voltage range VRV including a valley position. Then, the process proceeds to ST217.
The processing of ST217 to ST219 is equivalent to the processing of ST206 to ST208.
The processing of ST220 is similar to the processing of ST209 except that the index idx3 is incremented instead of the index idx1.
As described above, the operation of the first further embodiment of the first embodiment is executed.
The first further embodiment of the first embodiment also achieves effects equivalent to those of the first embodiment.
Further, according to the first further embodiment of the first embodiment, a circuit for determining the adjustment parameter AJST may not be implemented in the memory controller 1.

2.2 Second Further embodiment of First Embodiment

In the first embodiment and the first further embodiment of the first embodiment, the case where the memory controller 1 executes the setting of steps SS1, SS2, and SS3 and the calculation of the difference bit counts BC1, BC2, and BC3 has been described, but the present embodiment is not limited thereto. The setting of steps SS1, SS2, and SS3 and the calculation of the difference bit counts BC1, BC2, and BC3 may be executed by the memory device 2.

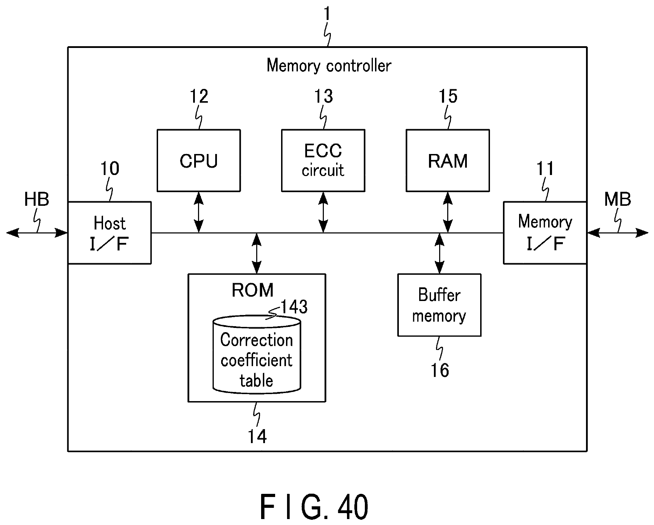

A configuration of a memory system MS according to a second further embodiment of the first embodiment will be described with reference to FIG. 40. FIG. 40 is a block diagram illustrating an example of a hardware configuration of a memory controller included in the memory system according to the second further embodiment of the first embodiment.

According to the second further embodiment of the first embodiment, a ROM 14 of a memory controller 1 stores a program such as firmware, for example. In the second further embodiment of the first embodiment, a step count table is stored in a memory device 2 instead of the ROM 14, as well as an adjustment parameter table. Other configurations are substantially equivalent to the configuration of the memory system according to the first further embodiment of the first embodiment.

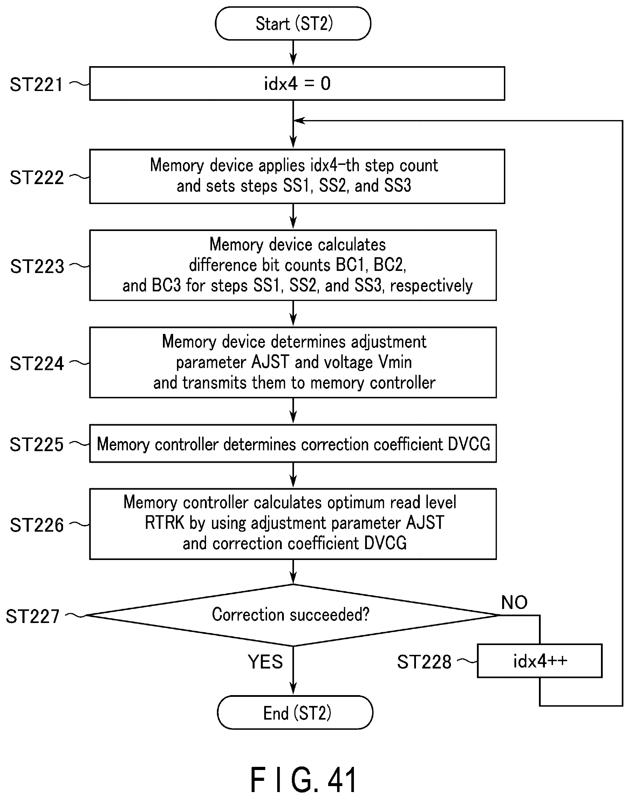

Next, a Vth tracking operation according to the second further embodiment of the first embodiment will be described with reference to FIG. 41. FIG. 41 is a flowchart for explaining an example of a part of the Vth tracking operation executed in the memory system according to the second further embodiment of the first embodiment. In the Vth tracking operation according to the second further embodiment of the first embodiment, the overall procedure and the process of determining a voltage range VRV including and a valley position may be equivalent to the Vth tracking operations according to the first embodiment and the first further embodiment of the first embodiment, and thus the description thereof will be omitted. Hereinafter, the process of calculating the optimum read level RTRK (ST2) will be mainly described in terms of differences from the first further embodiment of the first embodiment.

The processing of ST221 is similar to the processing of ST212 except that the index idx4 is used instead of the index idx3. Then, the processing proceeds to ST222.

The processing of ST222 is similar to the processing of ST213 except that the memory device 2 executes the processing instead of the memory controller 1 and the index idx4 is used. In the second further embodiment of the first embodiment, instead of the index idx3, a step count table stores indexes idx4 and step counts SCSS1, SCSS2, and SCSS3 corresponding to the indexes idx4.

The processing of ST223 is equivalent to the processing of ST214 except that the memory device 2 executes the processing instead of the memory controller 1. Then, the processing proceeds to ST224.

The processing of ST224 to ST227 is equivalent to the processing of ST216 to ST219.

The processing of ST228 is similar to the processing of ST220 except that the index idx4 is incremented instead of the index idx3.

As described above, the operation of the second further embodiment of the first embodiment is executed.

The second further embodiment of the first embodiment also achieves the same effects as those of the first embodiment.

Further, according to the second further embodiment of the first embodiment, the memory controller 1 may not be provided with a circuit that performs processing for setting steps SS1, SS2, and SS3 and calculating difference bit counts BC1, BC2, and BC3.

3 Second Embodiment

In the first embodiment, the first further embodiment of the first embodiment, and the second further embodiment of the first embodiment, the case where the settings of the step counts SCSS1, SCSS2, and SCSS3 are applied in the order designated by the index in the step count table has been described, but the present embodiment is not limited thereto. The settings of the step counts SCSS1, SCSS2, and SCSS3 may be determined according to the symmetry of two adjacent states.

Since a configuration of a memory system MS according to a second embodiment may be substantially equivalent to the configuration of the memory system MS according to the first embodiment, the description thereof will be omitted. Hereinafter, a Vth tracking operation according to the second embodiment will be mainly described.

3.1 Overall Procedure of Vth Tracking Operation

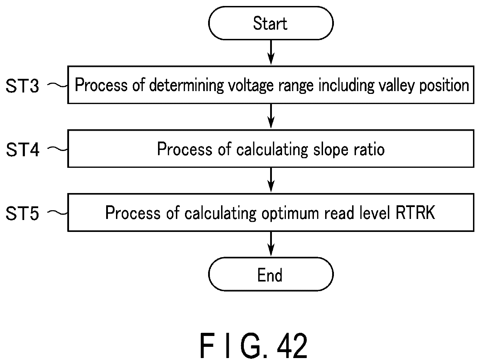

The overall procedure of a Vth tracking operation will be described with reference to FIG. 42. FIG. 42 is a flowchart for explaining an example of the Vth tracking operation executed in the memory system according to the second embodiment.

The processing of ST3 is equivalent to the processing of ST1. Then, the processing proceeds to ST4.

The memory system MS calculates a slope ratio between a slope on the low voltage side and a slope on the high voltage side of a valley formed by two adjacent states based on a difference bit count for each step value and a voltage range VRV including a valley position (ST4). A more specific description of the calculation of the slope ratio will be described later. Then, the processing proceeds to ST5.

In ST5, the memory system MS calculates an optimum read level according to the slope ratio calculated in the processing of ST4. A more specific description of the calculation of the optimum read level will be described later.

As described above, the optimum read level is calculated.

3.2 Calculation of Slope Ratio

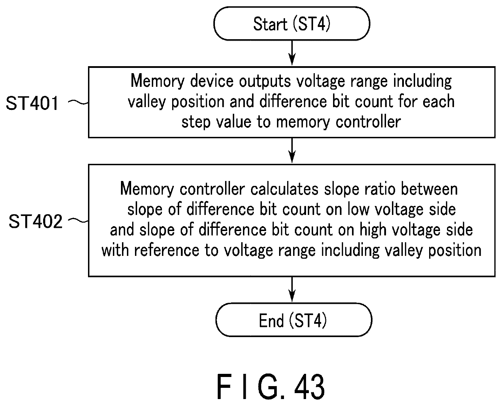

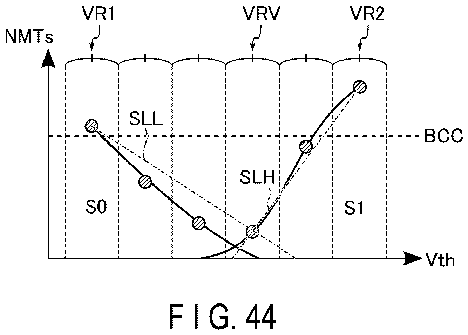

An example of the calculation of the slope ratio in ST4 will be described with reference to FIGS. 43 and 44. FIG. 43 is a flowchart for explaining an example of a part of the operation of the Vth tracking operation executed in the memory system according to the second embodiment. FIG. 44 is a schematic diagram for explaining an example of the slope ratio calculated in the memory system according to the second embodiment.

The processing of ST401 is equivalent to the processing of ST201. Then, the processing proceeds to ST402.

The memory controller 1 calculates a slope ratio SR (SLL/SLH) obtained by dividing a slope SLL of a difference bit count for each step value on the low voltage side by a slope SLH of a difference bit count for each step value on the high voltage side with reference to the voltage range VRV including the valley position (ST402). As illustrated in FIG. 44, the slope SLL is a value obtained by dividing a difference between a first difference bit count and a second difference bit count by a potential difference between the voltage range VRV and a first voltage range VR1. Here, the first difference bit count is the difference bit count corresponding to the voltage range VRV including the valley position. The second difference bit count is the difference bit count corresponding to the first voltage range VR1, which is on a lower voltage side than the voltage range VRV. The first voltage range VR1 is, for example, the highest voltage range among voltage ranges in each of which the difference bit count for each step value exceeds a reference value BCC, in the lower voltage side than the voltage range VRV. In addition, the potential difference is a potential difference between the higher (or lower) read level among the two read levels specifying the voltage range VRV and the higher (or lower) read level among the two read levels specifying the first voltage range VR1. As illustrated in FIG. 44, the slope SLH is a value obtained by dividing a difference between the first difference bit count and a third difference bit count by a potential difference between the voltage range VRV and a second voltage range VR2. Here, the third difference bit count is the difference bit count corresponding to the second voltage range VR2, which is on a higher voltage side than the voltage range VRV. The second voltage range VR2 is, for example, the lowest voltage range among voltage ranges in each of which the difference bit count for each step value exceeds the reference value BCC, in the higher voltage side than the voltage range VRV. In addition, the potential difference is a potential difference between the higher (or lower) read level among the two read levels specifying the voltage range VRV and the higher (or lower) read level among the two read levels specifying the second voltage range VR2.

Note that the method of calculating the slope ratio SR is not limited to the above-described method. The slope ratio SR may be a value calculated by various statistical methods for a difference bit count plot for each step value.

With the above, the processing of ST4 ends.

3.3 Calculation of Optimum Read Level

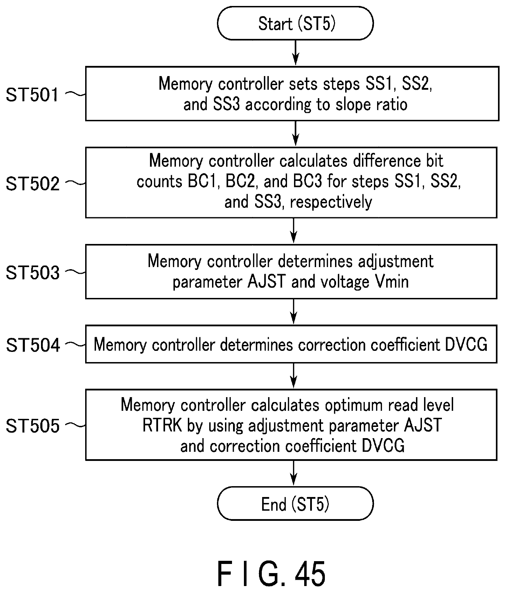

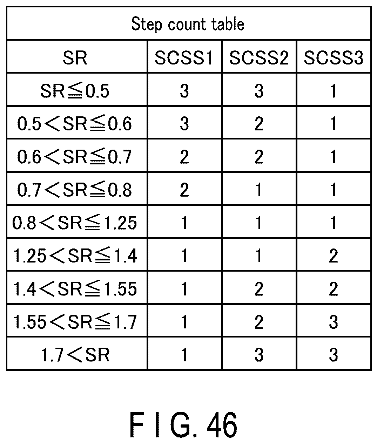

An example of the calculation of the optimum read level in ST5 will be described with reference to FIGS. 45 and 46. FIG. 45 is a flowchart for explaining an example of another part of the Vth tracking operation executed in the memory system according to the second embodiment. FIG. 46 is a diagram illustrating an example of the step count table used in the memory system according to the second embodiment.

In ST501, the memory controller 1 sets steps SS1, SS2, and SS3 according to the slope ratio SR calculated in ST4. According to the second embodiment, as illustrated in FIG. 46, the step count table 141 stores ranges of the slope ratio SR and the step counts SCSS1, SCSS2, and SCSS3 in association with each other. As a result, the memory controller 1 sets steps SS1, SS2, and SS3 based on the step counts SCSS1, SCSS2, and SCSS3 corresponding to the slope ratio SR and the voltage range VRV including the valley position as in the first embodiment.

Based on the step count table 141, for example, in a case where the slope ratio SR is in a range around 1 (0.8 < SR ≤ 1.25), that is, in a case where the slope SLH on the high voltage side and the slope SLL on the low voltage side are substantially the same, the memory controller 1 makes the step counts SCSS1 and SCSS3 equal to each other. In other words, the memory controller 1 symmetrically sets steps SS1 and SS3. In addition, the memory controller 1 makes the step count SCSS1 larger than the step count SCSS3 based on the step count table 141, for example, in a case where the slope ratio SR is smaller than the above range (0.8 ≤ SR), that is, in a case where the slope SLH on the high voltage side is larger than the slope SLL on the low voltage side. In other words, the memory controller 1 asymmetrically sets steps SS1 and SS3 such that step SS1 on the low voltage side, which has a small slope, is larger than step SS3 on the high voltage side, which has a large slope. Based on the step count table 141, for example, in a case where the slope ratio SR is larger than the above range (1.25 < SR), that is, in a case where the slope SLL on the low voltage side is larger than the slope SLH on the high voltage side, the memory controller 1 makes the step count SCSS3 larger than the step count SCSS1. In other words, the memory controller 1 asymmetrically sets steps SS1 and SS3 such that step SS3 on the high voltage side, which has a small slope, is larger than step SS1 on the low voltage side, which has a large slope. Then, the processing proceeds to ST502.

The processing of ST502 to ST505 is similar to the processing of ST204 to ST207. Then, the process ends (End (ST5)).

As described above, by setting steps SS1, SS2, and SS3 according to the calculated slope ratio SR, the optimum read level RTRK can be calculated according to the symmetry of the two adjacent states.

The second embodiment also has the same effects as those of the first embodiment.

Adding to the above, according to the second embodiment, the memory system MS sets steps SS1, SS2, and SS3 according to the slope ratio SR. In other words, the memory system MS sets steps SS1 and SS3 symmetrically or asymmetrically according to the slope ratio SR, for example. As a result, also according to the second embodiment, the memory system MS can determine the optimum read level RTRK with high accuracy regardless of the symmetry of the distributions of the states S(L-1) and S(L). Also, according to the second embodiment, after determining the voltage range including the valley position of the states S(L-1) and S(L), the memory system MS can calculate the difference bit counts BC1, BC2, and BC3 in steps SS1, SS2, and SS3, respectively, without newly performing shift reading using the upper limit voltage and the lower limit voltage of each step for determining the optimum read level.

In addition, according to the second embodiment, the memory system MS dynamically sets steps SS1, SS2, and SS3 according to the slope ratio SR as described above. By applying steps SS1, SS2, and SS3 set in this manner, the operation speed of the memory system MS can be improved.

The embodiments described above can be expressed as the following supplementary notes. However, the embodiments described above are not limited to the following supplementary notes.

Supplementary note 1. A memory system comprising: a memory device (2) that includes a plurality of memory cells (MT), each of the plurality of memory cells being configured to store, in a nonvolatile manner, at least data of a first value and data of aa second value according to a threshold voltage, the first value corresponding to the threshold voltage included in a first voltage range, the second value corresponding to the threshold voltage included in a second voltage range different from the first voltage range, the plurality of memory cells including at least a plurality of first memory cells and a plurality of second memory cells; and a memory controller (1) configured to write the data of the first value to each of a plurality of first memory cells, write the data of the second value to each of a plurality of second memory cells, and cause, in a tracking operation, the memory device to execute a read operation a plurality of times on the plurality of memory cells using a plurality of read levels respectively, any two adjacent read levels of the plurality of read levels having the same interval, the plurality of read levels being within a third voltage range that includes at least a part of the first voltage range and at least a part of the second voltage range, wherein in the tracking operation, the number of ON-cells, which is the number of memory cells that turn on among the plurality of memory cells, is acquired in each read operation using each read level, a plurality of first bit counts are calculated, each of the plurality of first bit counts being a difference in the numbers of ON-cells in each of two read operations using the two adjacent read levels, and a second bit count and a third bit count are calculated using the plurality of first bit counts, the second bit count corresponding to a fourth voltage range included in the third voltage range, the second bit count being a difference in the numbers of ON-cells in two read operations respectively using a read level equivalent to a lower limit voltage of the fourth voltage range and a read level equivalent to an upper limit voltage of the fourth voltage range, among the plurality of read levels, the third bit count corresponding to a fifth voltage range included in the third voltage range, the fifth voltage range having a voltage range different from the fourth voltage range, the third bit count being a difference in the numbers of ON-cells in two read operations respectively using a read level equivalent to a lower limit voltage of the fifth voltage range and a read level equivalent to an upper limit voltage of the fifth voltage range, among the plurality of read levels.

Supplementary note 2. The memory system according to Supplementary note 1, wherein the memory device is configured to: calculate the plurality of first bit counts.

Supplementary note 3. The memory system according to Supplementary note 2, wherein the memory device is further configured to: output the plurality of first bit counts to the memory controller.

Supplementary note 4. The memory system according to Supplementary note 1, wherein the memory controller is configured to: calculate a first voltage based on the second bit count and the third bit count.

Supplementary note 5. The memory system according to Supplementary note 4, wherein the memory device is configured to: determine a sixth voltage range in which the of the plurality of first bit counts is obtained, and the memory controller is configured to: calculate the first voltage from the sixth voltage range.

Supplementary note 6. The memory system according to Supplementary note 5, wherein the memory controller is further configured to: calculate, by using the second bit count and the third bit count, a first coefficient for calculating the first voltage.

Supplementary note 7. The memory system according to Supplementary note 6, wherein the memory controller is further configured to: calculate the first coefficient based on a second voltage that internally divides the sixth voltage range by a ratio between the second bit count and the third bit count.

Supplementary note 8. The memory system according to Supplementary note 7, wherein the memory controller is further configured to: determine a second coefficient based on at least one of the second bit count and the third bit count; obtain a seventh voltage range in which the sixth voltage range is shifted based on the second coefficient; and calculate the first voltage by using the sixth voltage range, the seventh voltage range, and the first coefficient.

Supplementary note 9. The memory system according to Supplementary note 4, wherein the memory device is configured to: calculate, by using the second bit count and the third bit count, a first coefficient for calculating the first voltage.

Supplementary note 10. The memory system according to Supplementary note 4, wherein the memory controller is further configured to: execute a first process of executing error correction of data read using the first voltage; determine the first voltage as an optimum read voltage in a case where the error correction succeeds in the first process; and calculate a third voltage different from the first voltage in a case where the error correction fails in the first process.

Supplementary note 11. The memory system according to Supplementary note 10, further comprising a storage element configured to store a first table that includes: a first setting for specifying a set of the fourth voltage range and the fifth voltage range; and a second setting for specifying a set of an eighth voltage range and a ninth voltage range that are included in the third voltage range and have a different voltage range from the set of the fourth voltage range and the fifth voltage range, wherein the memory controller is further configured to: calculate the first voltage by applying the first setting and executes the first process by using the calculated first voltage, and in a case where the error correction fails in the first process, a fourth bit count and a fifth bit count corresponding to each of the eighth voltage range and the ninth voltage range are calculated by applying the second setting, the fourth bit count being a difference in the numbers of ON-cells in two read operations respectively using a read level equivalent to a lower limit voltage of the eighth voltage range and a read level equivalent to an upper limit voltage of the eighth voltage range, among the plurality of read levels, and the fifth bit count being a difference in the numbers of ON-cells in two read operations respectively using a read level equivalent to a lower limit voltage of the ninth voltage range and a read level equivalent to an upper limit voltage of the ninth voltage range, among the plurality of read levels, and the memory controller is further configured to: calculate the third voltage using the fourth bit count and the fifth bit count; and execute a second process of executing error correction of data read using the calculated third voltage.

Supplementary note 12. The memory system according to Supplementary note 4, wherein in the tracking operation, a sixth bit count corresponding to a tenth voltage range is calculated by using the plurality of first bit counts, the tenth voltage range being included in the third voltage range and included between the fourth voltage range and the fifth voltage range, the sixth bit count being a difference in the numbers of ON-cells in two read operations respectively using a read level equivalent to a lower limit voltage of the tenth voltage range and a read level equivalent to an upper limit voltage of the tenth voltage range, among the plurality of read levels, and the memory controller is configured to: calculate the first voltage based on the sixth bit count in addition to the second bit count and the third bit count.

Supplementary note 13. The memory system according to Supplementary note 1, wherein in the tracking operation, the fourth voltage range and the fifth voltage range are determined based on a ratio of a first slope of distribution of the plurality of first bit counts and a second slope of the distribution of the plurality of first bit counts, the first slope corresponding to a voltage range closer to the first voltage range than to the second voltage range in the third voltage range, the second slope corresponding to a voltage range closer to the second voltage range than to the first voltage range in the third voltage range.

Supplementary note 14. The memory system according to Supplementary note 13, wherein the memory controller is further configured to calculate the ratio.

Supplementary note 15. The memory system according to Supplementary note 13, wherein the first voltage range is included in a lower voltage side than the second voltage range, the fourth voltage range is included in a lower voltage side than the fifth voltage range, in a case where the ratio is smaller than a lower limit of a first range, a voltage range of the fourth voltage range is determined to be larger than a voltage range of the fifth voltage range, and in a case where the ratio is larger than an upper limit of the first range, the voltage range of the fourth voltage range is determined to be smaller than the voltage range of the fifth voltage range.

Supplementary note 16. The memory system according to Supplementary note 1, wherein the memory controller is further configured to: calculate the second bit count and the third bit count by using the plurality of first bit counts.

Supplementary note 17. The memory system according to Supplementary note 1, wherein the memory device is configured to: calculate the second bit count and the third bit count by using the plurality of first bit counts.

4 Others

While certain embodiments have been described, these embodiments have been presented by way of example only, and are not intended to limit the scope of the inventions. Indeed, the novel embodiments described herein may be embodied in a variety of other forms. Furthermore, various omissions, substitutions, and changes in the form of the embodiments may be made. The accompanying claims and their equivalents are intended to cover such forms or further embodiments as would fall within the scope of the inventions.

**EP 4 779 641 A1**

**Claims**

1. A memory system comprising:

a memory device (2) that includes a plurality of memory cells (MT), each of the plurality of memory cells being configured to store, in a nonvolatile manner, at least data of a first value and data of a second value according to a threshold voltage, the first value corresponding to the threshold voltage included in a first voltage range, the second value corresponding to the threshold voltage included in a second voltage range different from the first voltage range, the plurality of memory cells including at least a plurality of first memory cells and a plurality of second memory cells; and
a memory controller (1) configured to:

write the data of the first value to each of a plurality of first memory cells;
write the data of the second value to each of a plurality of second memory cells; and
cause, in a tracking operation, the memory device to execute a read operation a plurality of times on the plurality of memory cells using a plurality of read levels respectively, any two adjacent read levels of the plurality of read levels having the same interval, the plurality of read levels being within a third voltage range that includes at least a part of the first voltage range and at least a part of the second voltage range, wherein

in the tracking operation,

the number of ON-cells, which is the number of memory cells that turn on among the plurality of memory cells, is acquired in each read operation using each read level,
a plurality of first bit counts are calculated, each of the plurality of first bit counts being a difference in the numbers of ON-cells in each of two read operations using the two adjacent read levels, and
a second bit count and a third bit count are calculated using the plurality of first bit counts,

the second bit count corresponding to a fourth voltage range included in the third voltage range, the second bit count being a difference in the numbers of ON-cells in two read operations respectively using a read level equivalent to a lower limit voltage of the fourth voltage range and a read level equivalent to an upper limit voltage of the fourth voltage range, among the plurality of read levels,
the third bit count corresponding to a fifth voltage range included in the third voltage range, the fifth voltage range having a voltage range different from the fourth voltage range, the third bit count being a difference in the numbers of ON-cells in two read operations respectively using a read level equivalent to a lower limit voltage of the fifth voltage range and a read level equivalent to an upper limit voltage of the fifth voltage range, among the plurality of read levels.

2. The memory system according to claim 1, wherein the memory device is configured to:
calculate the plurality of first bit counts.

3. The memory system according to claim 2, wherein the memory device is further configured to:
output the plurality of first bit counts to the memory controller.

4. The memory system according to claim 1, wherein the memory controller is configured to:
calculate a first voltage based on the second bit count and the third bit count.

5. The memory system according to claim 4, wherein

the memory device is configured to:
determine a sixth voltage range in which the minimum of the plurality of first bit counts is obtained, and
the memory controller is configured to:
calculate the first voltage from the sixth voltage range.

6. The memory system according to claim 5, wherein the memory controller is further configured to:
calculate, by using the second bit count and the third bit count, a first coefficient for calculating the first voltage.

7. The memory system according to claim 6, wherein the memory controller is further configured to:
calculate the first coefficient based on a second voltage that internally divides the sixth voltage range by a ratio between the second bit count and the third bit count.

8. The memory system according to claim 7, wherein
the memory controller is further configured to:

determine a second coefficient based on at least one of the second bit count and the third bit count;
obtain a seventh voltage range in which the sixth voltage range is shifted based on the second coefficient; and
calculate the first voltage by using the sixth voltage range, the seventh voltage range, and the first coefficient.

9. The memory system according to claim 4, wherein the memory device is configured to:
calculate, by using the second bit count and the third bit count, a first coefficient for calculating the first voltage.

10. The memory system according to claim 4, wherein
the memory controller is further configured to:

execute a first process of executing error correction of data read using the first voltage;
determine the first voltage as an optimum read voltage in a case where the error correction succeeds in the first process; and
calculate a third voltage different from the first voltage in a case where the error correction fails in the first process.

11. The memory system according to claim 10, further comprising:
a storage element configured to store a first table that includes:

a first setting for specifying a set of the fourth voltage range and the fifth voltage range; and
a second setting for specifying a set of an eighth voltage range and a ninth voltage range that are included in the third voltage range and have a different voltage range from the set of the fourth voltage range and the fifth voltage range, wherein
the memory controller is further configured to:
calculate the first voltage by applying the first setting and executes the first process by using the calculated first voltage, and
in a case where the error correction fails in the first process,

a fourth bit count and a fifth bit count corresponding to each of the eighth voltage range and the ninth voltage range are calculated by applying the second setting,
the fourth bit count being a difference in the numbers of ON-cells in two read operations respectively using a read level equivalent to a lower limit voltage of the eighth voltage range and a read level equivalent to an upper limit voltage of the eighth voltage range, among the plurality of read levels,
the fifth bit count being a difference in the numbers of ON-cells in two read operations respectively using a read level equivalent to a lower limit voltage of the ninth voltage range and a read level equivalent to an upper limit voltage of the ninth voltage range, among the plurality of read levels, and

the memory controller is further configured to:

calculate the third voltage using the fourth bit count and the fifth bit count; and
execute a second process of executing error correction of data read using the calculated third voltage.

12. The memory system according to claim 4, wherein
in the tracking operation,

a sixth bit count corresponding to a tenth voltage range is calculated by using the plurality of first bit counts, the tenth voltage range being included in the third voltage range and included between the fourth voltage range and the fifth voltage range,
the sixth bit count being a difference in the numbers of ON-cells in two read operations respectively using a read level equivalent to a lower limit voltage of the tenth voltage range and a read level equivalent to an upper limit voltage of the tenth voltage range, among the plurality of read levels, and
the memory controller is configured to:
calculate the first voltage based on the sixth bit count in addition to the second bit count and the third bit count.

13. The memory system according to claim 1, wherein
in the tracking operation, the fourth voltage range and the fifth voltage range are determined based on a ratio of a first slope of distribution of the plurality of first bit counts and a second slope of the distribution of the plurality of first bit counts,

the first slope corresponding to a voltage range closer to the first voltage range than to the second voltage range in the third voltage range,
the second slope corresponding to a voltage range closer to the second voltage range than to the first voltage range in the third voltage range.

14. The memory system according to claim 13, wherein the memory controller is further configured to calculate the ratio.

15. The memory system according to claim 13, wherein

the first voltage range is included in a lower voltage side than the second voltage range,
the fourth voltage range is included in a lower voltage side than the fifth voltage range,
in a case where the ratio is smaller than a lower limit of a first range, a voltage range of the fourth voltage range is determined to be larger than a voltage range of the fifth voltage range, and
in a case where the ratio is larger than an upper limit of the first range, the voltage range of the fourth voltage range is determined to be smaller than the voltage range of the fifth voltage range.

F I G. 1

F I G. 2

F I G. 3

F I G. 4

F I G. 5

F I G. 6

| Page | Data | | | | | | | |
|------|---|---|---|---|---|---|---|---|
| Upper | 1 | 1 | 1 | 0 | 0 | 0 | 0 | 1 |
| Middle | 1 | 1 | 0 | 0 | 1 | 1 | 0 | 0 |
| Lower | 1 | 0 | 0 | 0 | 0 | 1 | 1 | 1 |

NMTs

S0  S1  S2  S3  S4  S5  S6  S7

VREAD  Vth

Read voltage

R3                    R7    Upper page
R2        R4      R6         Middle page
R1                  R5       Lower page

# F I G. 7

(A)

NMTs

S(L-1)    S(L)

R(L)def    Vth

(B)

NMTs

S(L-1)    R(L)n    S(L)

R(L)def    Vth

# F I G. 8

FIG. 9

F I G. 10

F I G. 11

FIG. 12

Start

ST1 ～ Process of determining voltage range including valley position

ST2 ～ Process of calculating optimum read level RTRK

End

F I G. 13

Start (ST1)

ST101 — Memory controller selects tracking parameter

ST102 — Memory device performs plurality of times of shift reading and calculates number of ON-cells in each shift reading

ST103 — Memory device calculates difference bit count for each step value

ST104 — Memory device specifies voltage range including valley position based on difference bit count for each step value

End (ST1)

F I G. 14

Start (ST2)

ST201 — Memory device outputs voltage range including valley position and difference bit count for each step value to memory controller

ST202 — idx1 = 0

ST203 — Memory controller applies idx1-st step count and sets steps SS1, SS2, and SS3

ST204 — Memory controller calculates difference bit counts BC1, BC2, and BC3 for steps SS1, SS2, and SS3, respectively

ST205 — Memory controller determines adjustment parameter AJST and voltage Vmin

ST206 — Memory controller determines correction coefficient DVCG

ST207 — Memory controller calculates optimum read level RTRK by using adjustment parameter AJST and correction coefficient DVCG

ST208 — Correction succeeded?

NO

ST209 — idx1++

YES

End (ST2)

F I G. 15

| Step count table | | | |
|---|---|---|---|
| idx1 | SCSS1 | SCSS2 | SCSS3 |
| 0 | 3 | 3 | 1 |
| 1 | 3 | 2 | 1 |
| 2 | 2 | 2 | 1 |
| 3 | 2 | 1 | 1 |
| 4 | 1 | 1 | 1 |
| 5 | 1 | 1 | 2 |
| 6 | 1 | 2 | 2 |
| 7 | 1 | 2 | 3 |
| 8 | 1 | 3 | 3 |

F I G. 16

SS1  SS2  SS3

Step values

Vth

F I G. 17

F I G. 18

F I G. 19

F I G. 20

F I G. 21

F I G. 22

F I G. 23

F I G. 24

| Adjustment parameter table | |
|---|---|
| RBC range | AJST |
| $-1.00 \leqq RBC \leqq -0.67$ | $+1/2$ |
| $-0.67 < RBC \leqq -0.33$ | $+1/4$ |
| $-0.33 < RBC \leqq 0.33$ | $0$ |
| $0.33 < RBC \leqq 0.67$ | $-1/4$ |
| $0.67 < RBC \leqq 1.00$ | $-1/2$ |

F I G. 25

Difference bit count

F I G. 26

Difference bit count

F I G. 27

| Correction coefficient table | | |
|---|---|---|
| idx2 | DVCG1 | DVCG2 |
| 0 | DVRV | DVRV |
| 1 | $(1/2) \times DVRV$ | DVRV |
| 2 | $(1/2) \times DVRV$ | $(3/2) \times DVRV$ |
| 3 | DVRV | $(1/2) \times DVRV$ |
| 4 | $(3/2) \times DVRV$ | $(1/2) \times DVRV$ |

# F I G. 28

VRV

$0 < RBC \leqq 0.33$
$-0.33 < RBC \leqq 0$
$0.33 < RBC \leqq 0.67$
$-0.67 < RBC \leqq -0.33$
$0.67 < RBC \leqq 1.00$
$-1.00 \leqq RBC \leqq -0.67$

Vth

Vmin          Vmid

AJST (idx2=0)

| -1/2 | -1/4 | 0 | 0 | +1/4 | +1/2 |

Equivalent to RTRK'ap

AJST (idx2=1,2)

| -1/2 | -1/4 | 0 | 0 | +1/4 | +1/2 |

Shifted to high voltage side than RTRK'ap

AJST (idx2=3,4)

| -1/2 | -1/4 | 0 | 0 | +1/4 | +1/2 |

Shifted to low voltage side than RTRK'ap

# F I G. 29

46

Difference bit count

VRV_s1

VRVL          VRVH

VRV

BC3

Deviation

BC1

BC2

Vth

Vmin          Vmid  Vmin+DVRV  Vmin+DVRV+VS2
Vmin+VS1

RTRK'

Actual optimum read level RBST

F I G. 30

Difference bit count

VRV_s2

VRVL          VRVH

VRV

BC1

BC3          Deviation

BC2

Vth

Vmin+VS1  Vmin          Vmid          Vmin+DVRV

RTRK'  Vmin+DVRV+VS2

Actual optimum read level RBST

F I G. 31

F I G. 32

F I G. 33

$$VRVL : VRVH = (BC1-BC2) : (BC3-BC2)$$

Difference bit count

VRVL    VRVH

VRV

BC3=N4
(SCSS3=1)

BC1=N1+N2
(SCSS1=2)

BC2=N3
(SCSS2=1)

Vmin   RTRK1    Vmin+DVRV    Vth

RTRK2

Actual optimum read level RBST

F I G. 34

SS1   SS2   SS3

NMTs

S6    S7

Actual optimum read level RBST    Vth

RTRK

F I G. 35

VRVL : VRVH =
(BC1−BC2) : (BC3−BC2)

Difference bit count

VRVL        VRVH

VRV

BC1=N2
(SCSS1=1)

BC3=N4
(SCSS3=1)

BC2=N3
(SCSS2=1)

Vmin                    RTRK3    Vmin+DVRV    Vth

Actual optimum read level RBST

F I G. 36

VRVL : VRVH =
(BC1−BC2) : (BC3−BC2)

Difference bit count

VRVL        VRVH

VRV

BC1=N2
(SCSS1=1)

BC3=N4+N5
(SCSS3=2)

BC2=N3
(SCSS2=1)

Vmin                    RTRK3    Vmin+DVRV    Vth

RTRK4

Actual optimum read level RBST

F I G. 37

F I G. 38

Start (ST2)

ST211 — Memory device outputs voltage range including valley position and difference bit count for each step value to memory controller

ST212 — idx3 = 0

ST213 — Memory controller applies idx3-rd step count and sets steps SS1, SS2, and SS3

ST214 — Memory controller calculates difference bit counts BC1, BC2, and BC3 for steps SS1, SS2, and SS3, respectively

ST215 — Memory controller transmits difference bit counts BC1, BC2, and BC3 and parameter determination command to memory device

ST216 — Memory device determines adjustment parameter AJST and voltage Vmin and transmits them to memory controller

ST217 — Memory controller determines correction coefficient DVCG

ST218 — Memory controller calculates optimum read level RTRK by using adjustment parameter AJST and correction coefficient DVCG

ST219 — Correction succeeded?  — NO → ST220 — idx3++

YES

End (ST2)

F I G. 39

1

Memory controller

| 12 | 13 | 15 |
|---|---|---|
| CPU | ECC circuit | RAM |

10

HB

Host I/F

ROM

143

Correction coefficient table

14

Buffer memory

16

11

Memory I/F

MB

F I G. 40

Start (ST2)

ST221 — idx4 = 0

ST222 — Memory device applies idx4-th step count and sets steps SS1, SS2, and SS3

ST223 — Memory device calculates difference bit counts BC1, BC2, and BC3 for steps SS1, SS2, and SS3, respectively

ST224 — Memory device determines adjustment parameter AJST and voltage Vmin and transmits them to memory controller

ST225 — Memory controller determines correction coefficient DVCG

ST226 — Memory controller calculates optimum read level RTRK by using adjustment parameter AJST and correction coefficient DVCG

ST227 — Correction succeeded?

NO

ST228 — idx4++

YES

End (ST2)

F I G. 41

Start

ST3 — Process of determining voltage range including valley position

ST4 — Process of calculating slope ratio

ST5 — Process of calculating optimum read level RTRK

End

F I G. 42

Start (ST4)

ST401 — Memory device outputs voltage range including valley position and difference bit count for each step value to memory controller

ST402 — Memory controller calculates slope ratio between slope of difference bit count on low voltage side and slope of difference bit count on high voltage side with reference to voltage range including valley position

End (ST4)

F I G. 43

FIG. 44

Start (ST5)

ST501 — Memory controller sets steps SS1, SS2, and SS3 according to slope ratio

ST502 — Memory controller calculates difference bit counts BC1, BC2, and BC3 for steps SS1, SS2, and SS3, respectively

ST503 — Memory controller determines adjustment parameter AJST and voltage Vmin

ST504 — Memory controller determines correction coefficient DVCG

ST505 — Memory controller calculates optimum read level RTRK by using adjustment parameter AJST and correction coefficient DVCG

End (ST5)

F I G. 45

| Step count table | | | |
|---|---|---|---|
| SR | SCSS1 | SCSS2 | SCSS3 |
| SR≦0.5 | 3 | 3 | 1 |
| 0.5＜SR≦0.6 | 3 | 2 | 1 |
| 0.6＜SR≦0.7 | 2 | 2 | 1 |
| 0.7＜SR≦0.8 | 2 | 1 | 1 |
| 0.8＜SR≦1.25 | 1 | 1 | 1 |
| 1.25＜SR≦1.4 | 1 | 1 | 2 |
| 1.4＜SR≦1.55 | 1 | 2 | 2 |
| 1.55＜SR≦1.7 | 1 | 2 | 3 |
| 1.7＜SR | 1 | 3 | 3 |

F I G. 46

| | Europäisches Patentamt European Patent Office Office européen des brevets | **EUROPEAN SEARCH REPORT** | **Application Number** EP 25 19 1191 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | US 2019/259459 A1 (TOKUTOMI TSUKASA [JP] ET AL) 22 August 2019 (2019-08-22)<br>* [0095], [0135], [0139], [0143], [0207], [0224];<br>figures 1,2,5,9,11 * | 1-10, 12-14<br>11,15 | INV.<br>G11C16/34<br>G11C29/52<br>G11C16/26 |
| | ----- | | ADD.<br>G11C16/04 |
| A | US 2023/096401 A1 (KIYOOKA MASAHIRO [JP] ET AL) 30 March 2023 (2023-03-30)<br>* figure 17 * | 1-15 | |
| | ----- | | |

TECHNICAL FIELDS
SEARCHED     (IPC)

G11C

The present search report has been drawn up for all claims

| Place of search | Date of completion of the search | Examiner |
|---|---|---|
| The Hague | 10 December 2025 | Kearey, Robin |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
...............................................................................
& : member of the same patent family, corresponding
    document

EPO FORM 1503 03.82 (P04C01)

**ANNEX TO THE EUROPEAN SEARCH REPORT
ON EUROPEAN PATENT APPLICATION NO.**

EP 25 19 1191

This annex lists the patent family members relating to the patent documents cited in the above-mentioned European search report.
The members are as contained in the European Patent Office EDP file on
The European Patent Office is in no way liable for these particulars which are merely given for the purpose of information.

10-12-2025

| Patent document cited in search report | Publication date | Patent family member(s) | | Publication date |
|---|---|---|---|---|
| US 2019259459 A1 | 22-08-2019 | JP | 2018163724 A | 18-10-2018 |
| | | US | 2018277226 A1 | 27-09-2018 |
| | | US | 2019259459 A1 | 22-08-2019 |
| | | US | 2021104282 A1 | 08-04-2021 |
| | | US | 2022270687 A1 | 25-08-2022 |
| US 2023096401 A1 | 30-03-2023 | JP | 2023045614 A | 03-04-2023 |
| | | US | 2023096401 A1 | 30-03-2023 |

EPO FORM P0459

For more details about this annex : see Official Journal of the European Patent Office, No. 12/82

**EP 4 779 641 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2025005553 A